# EUROPEAN PATENT APPLICATION

(11) **EP 3 582 277 A1**
(43) Date of publication of application: **18.12.2019**
(21) Application number: 17896142.1
(22) Date of filing: 09.02.2017
(51) Int. Cl.: H01L 51/50, C08G 61/00, C08G 61/12, H05B 33/02

(54) **ORGANIC ELECTRONICS MATERIAL, ORGANIC ELECTRONICS ELEMENT, AND ORGANIC ELECTROLUMINESCENT ELEMENT**

(71) Applicant: Hitachi Chemical Company, Ltd., Chiyoda-ku Tokyo 100-6606 (JP)
(72) Inventor: SUGIOKA Tomotsugu, Tokyo 100-6606 (JP); ISHITSUKA Kenichi, Tokyo 100-6606 (JP); HONNA Ryo, Tokyo 100-6606 (JP); SAKUMA Hirotaka, Tokyo 100-6606 (JP)
(74) Representative: Adam, Holger
(86) International application number: PCT/JP2017/004797
(87) International publication number: WO 2018/146779

(57) **Abstract**

One embodiment relates to an organic electronic material containing a charge transport polymer or oligomer having a crosslinking group represented by formula (1) shown below at least at one terminal, and also having a crosslinking group represented by formula (2) shown below at least at one terminal. In formula (1), each of R^{a} to R^{g} independently represents a hydrogen atom or a substituent. In formula (2), each of R^{a} to R^{c} independently represents a hydrogen atom or a substituent.

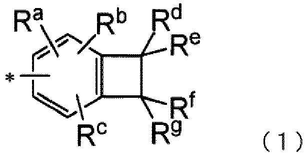

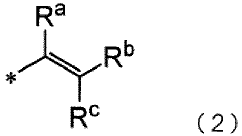

## Description

### Technical Field

The present disclosure relates to an organic electronic material, a liquid composition, an organic layer, an organic electronic element, an organic electroluminescent element (organic EL element), a display element, an illumination device, and a display device.

### Background Art

Organic EL elements are attracting attention for potential use in large-surface area solid state lighting applications to replace incandescent lamps or gas-filled lamps. Further, organic EL elements are also attracting attention as the leading self-luminous display for replacing liquid crystal displays (LCD) in the field of flat panel displays (FPD), and commercial products are becoming increasingly available.

Depending on the organic materials used, organic EL elements are broadly classified into two types: low-molecular weight type organic EL elements and polymer type organic EL elements. In polymer type organic EL elements, a polymer compound is used as the organic material, whereas in low-molecular weight type organic EL elements, a low-molecular weight compound is used. On the other hand, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Because wet processes enable simple film formation, they are expected to be an indispensable method in the production of future large-screen organic EL displays.

Accordingly, much development of materials suitable for wet processes is being pursued. For example, investigations are being undertaken into the formation of multilayer structures using compounds having polymerizable groups (for example, see Patent Literature 1).

### Citation List

### Patent Literature

PLT 1: JP 2009-283509 A

### Summary of Invention

### Technical Problem

The present disclosure provides an organic electronic material and a liquid composition that exhibit satisfactory curability of a level suitable for wet processes, and are suitable for improving the characteristics of organic electronic elements. Further, the present disclosure also provides an organic layer that is suitable for improving the characteristics of organic electronic elements. Moreover, the present disclosure also provides an organic electronic element, an organic EL element, a display element, an illumination device and a display device having excellent characteristics.

### Solution to Problem

The present invention includes many embodiments. Examples of these embodiments are described below. However, the present invention is not limited to the following embodiments.

One embodiment relates to an organic electronic material containing a charge transport polymer or oligomer having a crosslinking group represented by formula (1) shown below at least at one terminal, and also having a crosslinking group represented by formula (2) shown below at least at one terminal. 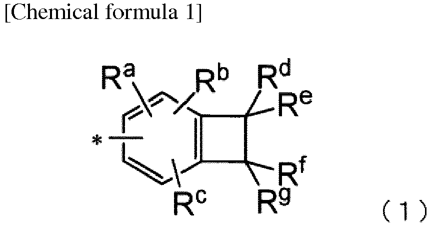 (In formula (1), each of R^{a} to R^{g} independently represents a hydrogen atom or a substituent.) 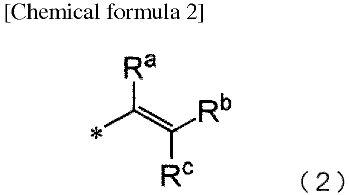 (In formula (2), each of R^{a} to R^{c} independently represents a hydrogen atom or a substituent.)

According to one embodiment, the charge transport polymer or oligomer has at least three terminals.

According to one embodiment, the charge transport polymer or oligomer contains at least a divalent structural unit L and a monovalent structural unit T, wherein the structural unit L includes a structural unit containing at least one type of structure selected from the group consisting of a substituted or unsubstituted aromatic amine structure and a substituted or unsubstituted carbazole structure, and the monovalent structural unit T includes a monovalent structural unit T1 containing a crosslinking group represented by the above formula (1) and a monovalent structural unit T2 containing a crosslinking group represented by the above formula (2).

According to one embodiment, the charge transport polymer or oligomer also contains at least one type of structural unit selected from the group consisting of a trivalent or higher structural unit B and a monovalent structural unit T3 that does not contain a crosslinking group represented by the above formula (1) or a crosslinking group represented by the above formula (2), wherein the structural unit B includes a structural unit containing at least one type of structure selected from the group consisting of a substituted or unsubstituted aromatic amine structure, a substituted or unsubstituted carbazole structure and a substituted or unsubstituted condensed polycyclic aromatic hydrocarbon structure, and the structural unit T3 includes a structural unit containing a substituted or unsubstituted aromatic ring structure.

According to one embodiment, in the charge transport polymer or oligomer, adjacent structural units selected from the group consisting of the structural unit L, the structural unit T and the optionally included structural unit B are bonded together by direct bonding of aromatic rings.

According to one embodiment, the charge transport polymer or oligomer is a copolymer of monomers including at least a difunctional monomer containing a structural unit having charge transport properties, a monofunctional monomer T1 containing a crosslinking group represented by formula (1), and a monofunctional monomer T2 containing a crosslinking group represented by formula (2).

According to one embodiment, the charge transport polymer or oligomer is a copolymer of monomers including at least a difunctional monomer containing a structural unit having hole transport properties, a monofunctional monomer T1 containing a crosslinking group represented by formula (1), and a monofunctional monomer T2 containing a crosslinking group represented by formula (2).

Another embodiment relates to a liquid composition containing any of the organic electronic materials described above and a solvent.

Another embodiment relates to an organic layer formed using any of the organic electronic materials described above or the liquid composition described above.

Another embodiment relates to an organic electronic element containing at least one of the above organic layer.

According to one embodiment, the organic electronic element contains at least an anode and cathode pair, and at least one of the above organic layer disposed between the anode and the cathode.

Another embodiment relates to an organic electroluminescent element containing at least one of the above organic layer.

According to one embodiment, the organic electroluminescent element contains at least a substrate, an anode, a light-emitting layer and a cathode, wherein the light-emitting layer is the organic layer described above.

According to one embodiment, the organic electroluminescent element contains at least a substrate, an anode, a hole injection layer, a hole transport layer, a light-emitting layer and a cathode, wherein at least one layer selected from the group consisting of the hole injection layer, the hole transport layer and the light-emitting layer is the organic layer described above.

According to one embodiment, the organic electroluminescent element contains at least a substrate, an anode, a hole injection layer, a hole transport layer, a light-emitting layer, an electron transport layer, an electron injection layer and a cathode, wherein at least one layer selected from the group consisting of the hole injection layer, the hole transport layer and the light-emitting layer is the organic layer described above.

Another embodiment relates to a display element containing the organic electroluminescent element described above.

Another embodiment relates to an illumination device containing any of the organic electroluminescent elements described above.

Another embodiment relates to a display device containing the illumination device described above, and a liquid crystal element as a display unit.

### Advantageous Effects of Invention

The present disclosure can provide an organic electronic material and a liquid composition that exhibit satisfactory curability of a level suitable for wet processes, and are suitable for improving the characteristics of organic electronic elements. Further, the present disclosure can also provide an organic layer that is suitable for improving the characteristics of organic electronic elements. Moreover, the present disclosure can also provide an organic electronic element, an organic EL element, a display element, an illumination device and a display device having excellent characteristics.

### Brief Description of Drawings

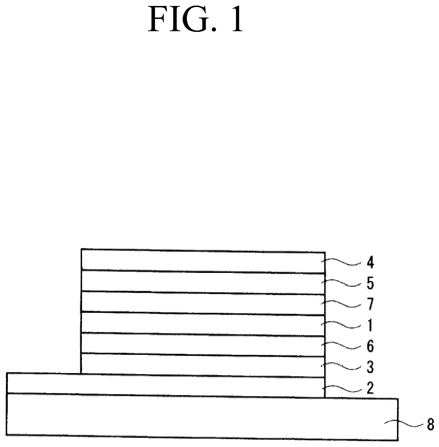

FIG. 1 is a cross-sectional schematic view illustrating one example of an organic EL element of one embodiment.

### Description of Embodiments

Embodiments of the present invention are described below. The present invention is not limited to the following embodiments.

### <Organic Electronic Material>

According to one embodiment, the organic electronic material contains a charge transport polymer or oligomer having a crosslinking group represented by formula (1) shown below at least at one terminal, and also having a crosslinking group represented by formula (2) shown below at least at one terminal (hereafter the "charge transport polymer or oligomer" is sometimes referred to as "the charge transport polymer", the "crosslinking group represented by formula (1)" is sometimes referred to as "the crosslinking group (1)", and the "crosslinking group represented by formula (2)" is sometimes referred to as "the crosslinking group (2)"). The organic electronic material may contain only one type of the charge transport polymer, or may contain two or more types. The charge transport polymer is preferred compared with low-molecular weight compounds in terms of exhibiting superior film formability in wet processes.

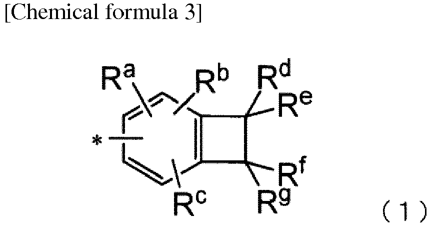

In formula (1), each of R^{a} to R^{g} independently represents a hydrogen atom or a substituent. In the present disclosure, "*" in a formula indicates a bonding site with another structure.

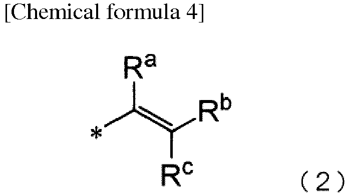

In formula (2), each of R^{a} to R^{c} independently represents a hydrogen atom or a substituent.

### [Charge Transport Polymer or Oligomer]

In one embodiment, the charge transport polymer has the ability to transport an electric charge. The charge transport polymer has the crosslinking group (1) at least at one terminal, and has the crosslinking group (2) at least at one terminal. A terminal describes an end of the polymer chain. The "at least one terminal" at which the crosslinking group (2) exists is preferably different from the "at least one terminal" at which the crosslinking group (1) exists. The charge transport polymer may have only one type of each of the crosslinking group (1) and the crosslinking group (2), or may have two or more types of each crosslinking group.

The crosslinking group (1) exists at least at one terminal of the charge transport polymer, and the crosslinking group (2) exists at least at one terminal of the charge transport polymer. Having the crosslinking groups at terminals of the charge transport polymer enables a high degree of curability to be obtained. Further, compared with cases where the polymer has crosslinking groups partway long the polymer chain (for example, cases in which the structural unit L and/or the structural unit B described below have a crosslinking group), the effect of the crosslinking groups on the charge transport properties of the charge transport polymer can be suppressed. Moreover, because the crosslinking groups are introduced at the terminals of the charge transport polymer, design and synthesis of the desired charge transport polymer can be achieved more easily.

The charge transport polymer may have two terminals, or may have three or more terminals. Charge transport polymers that have two terminals are linear polymers that contain no branched portions on the polymer chain, whereas charge transport polymers that have three or more terminals are branched polymers that include a branched portion on the polymer chain. The charge transport polymer may be linear or branched. Furthermore, when the charge transport polymer is a branched polymer, the crosslinking group (1) and the crosslinking group (2) may be introduced into the main chain of the charge transport polymer, may be introduced into a side chain, or may be introduced into both the main chain and a side chain.

According to one embodiment, the charge transport polymer preferably contains at least a divalent structural unit L and a monovalent structural unit T that forms the terminal portions, and may also contain a trivalent or higher structural unit B that forms a branched portion. Further, in another embodiment, the charge transport polymer preferably contains at least a trivalent structural unit B and a monovalent structural unit T that forms the terminal portions, and may also contain a divalent structural unit L. The charge transport polymer may have only one type of each of these structural units, or may contain a plurality of types of each structural unit. In the charge transport polymer, the various structural units are bonded together at "monovalent" to "trivalent or higher" bonding sites. The bonding preferably involves direct bonding of aromatic rings. From this viewpoint, the charge transport polymer is a polymer in which "adjacent structural units selected from the group consisting of the structural unit L, the structural unit T and the optionally included structural unit B", or "adjacent structural units selected from the group consisting of the structural unit B, the structural unit T and the optionally included structural unit L" are bonded together by direct bonding of aromatic rings.

The charge transport polymer has the crosslinking group (1) at least at one terminal, and has the crosslinking group (2) at least at one terminal. Accordingly, at least a portion of the structural units T contained in the charge transport polymer is the structural unit T1 containing the crosslinking group (1), and at least a portion of the structural units T is the structural unit T2 containing the crosslinking group (2). Moreover, at least a portion of the structural units T may be the structural unit T3 containing neither the crosslinking group (1) nor the crosslinking group (2).

Because the charge transport polymer has a combination of the crosslinking group (1) and the crosslinking group (2), superior curability can be obtained compared with charge transport polymers having other crosslinking groups. Further, by using a charge transport polymer having a combination of the crosslinking group (1) and the crosslinking group (2), organic electronic elements having excellent characteristics such as lifespan characteristics can be obtained.

In one preferred embodiment, the charge transport polymer contains at least a structural unit L and a structural unit T, wherein the structural unit L includes a structural unit containing at least one type of structure selected from the group consisting of substituted or unsubstituted aromatic amine structures and substituted or unsubstituted carbazole structures, and the structural unit T includes the structural unit T1 containing the crosslinking group (1) and the structural unit T2 containing the crosslinking group (2). Further, in another preferred embodiment, in addition to the above structural unit L and the above structural unit T, the charge transport polymer also contains at least one type of structural unit selected from the group consisting of a structural unit B and a structural unit T3 that does not contain the crosslinking group (1) or the crosslinking group (2), wherein the structural unit B includes a structural unit containing at least one type of structure selected from the group consisting of substituted or unsubstituted aromatic amine structures, substituted or unsubstituted carbazole structures and substituted or unsubstituted condensed polycyclic aromatic hydrocarbon structures, and the structural unit T3 includes a structural unit containing a substituted or unsubstituted aromatic ring structure.

### (Structure)

Examples of partial structures contained in the charge transport polymer include the structures described below. However, the charge transport polymer is not limited to polymers having the following partial structures. In the partial structures, "L" represents a structural unit L, "T" represents a structural unit T, and "B" represents a structural unit B. In the following partial structures, the plurality of L structural units may be structural units having the same structure or structural units having mutually different structures. This also applies for the B and T structural units.

### Linear Charge Transport Polymers

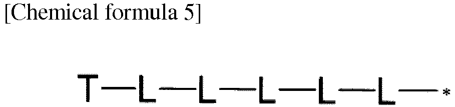

### Branched Charge Transport Polymers

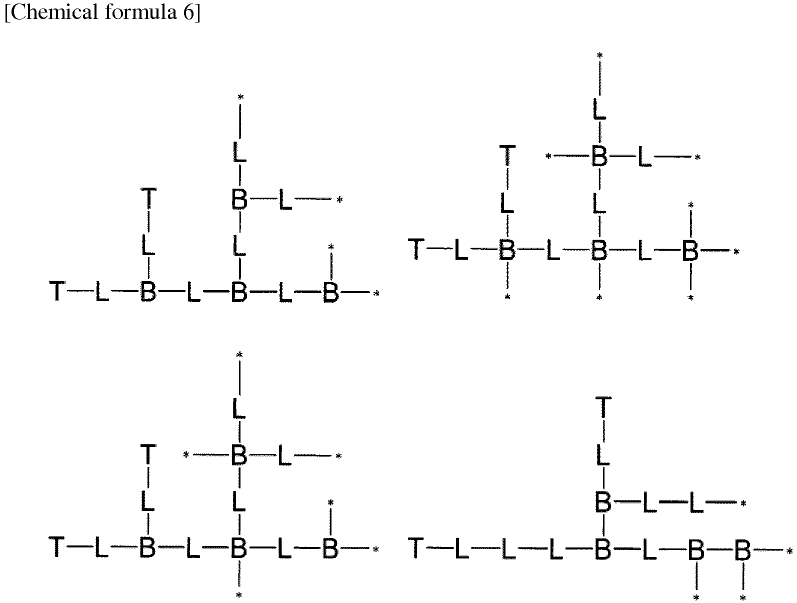

### (Structural unit L)

The structural unit L is preferably a structural unit having charge transport properties. There are no particular limitations on the structural unit having charge transport properties, provided it includes an atom grouping having the ability to transport an electric charge. For example, the structural unit L contains at least one type of structure selected from the group consisting of substituted or unsubstituted structures including aromatic amine structures, carbazole structures, thiophene structures, fluorene structures, benzene structures, biphenylene structures, terphenylene structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures and benzotriazole structures. The aromatic amine structure is preferably a triarylamine structure, and more preferably a triphenylamine structure. In those cases where any of these structures has a substituent, examples of the substituent include the substituent R^{A} described below, with the substituent R^{E} described below being preferred, and the substituent R^{B} described below being more preferred.

In one embodiment, from the viewpoint of obtaining superior hole transport properties, the structural unit L preferably contains at least one type of structure selected from the group consisting of substituted or unsubstituted structures including aromatic amine structures, carbazole structures, thiophene structures, fluorene structures, benzene structures and pyrrole structures, and more preferably contains at least one type of structure selected from the group consisting of substituted or unsubstituted aromatic amine structures and substituted or unsubstituted carbazole structures. In another embodiment, from the viewpoint of obtaining superior electron transport properties, the structural unit L preferably contains at least one type of structure selected from the group consisting of substituted or unsubstituted structures including fluorene structures, benzene structures, phenanthrene structures, pyridine structures and quinoline structures. In those cases where any of these structures has a substituent, examples of the substituent include the substituent R^{A} described below, with the substituent R^{E} described below being preferred, and the substituent R^{B} described below being more preferred.

Specific examples of the structural unit L are shown below. However, the structural unit L is not limited to the following structures.

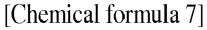

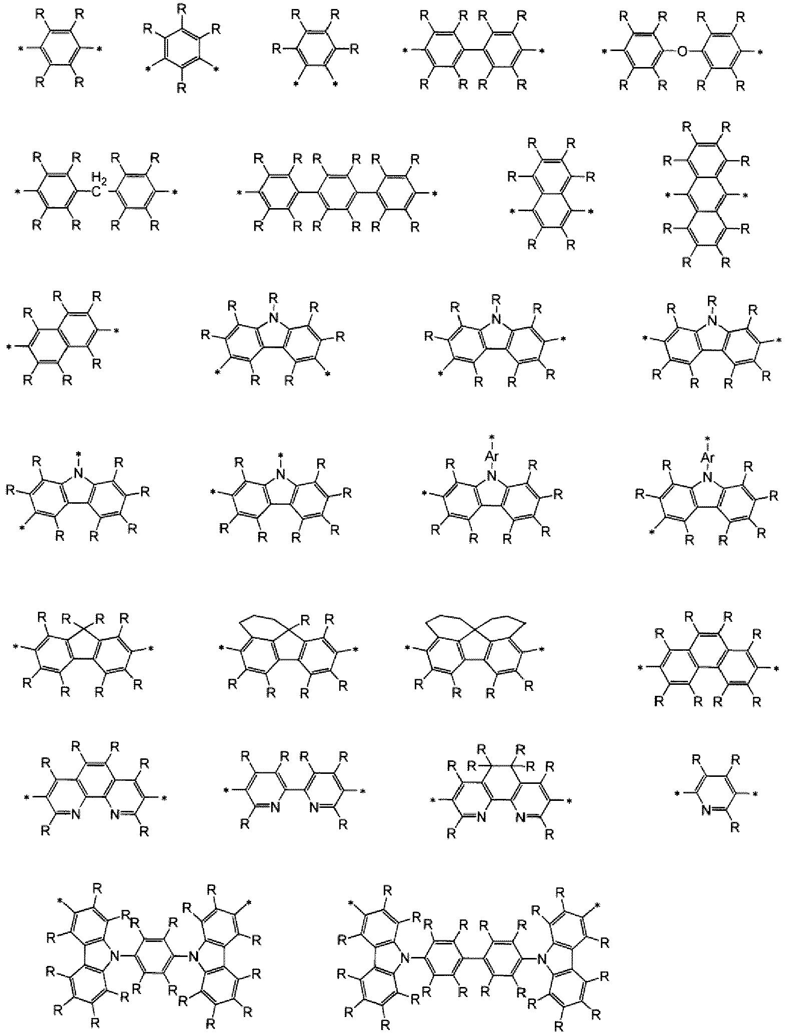

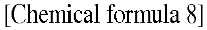

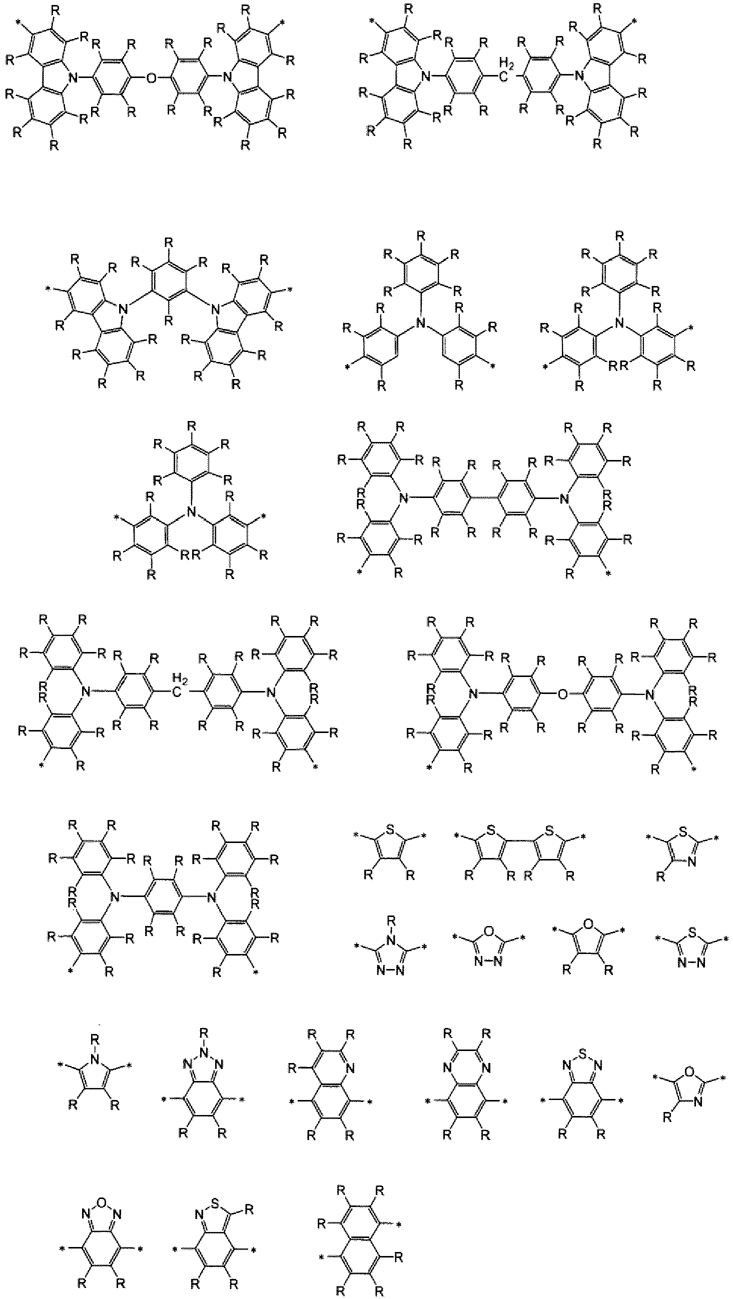

Each R independently represents a hydrogen atom or a substituent. It is preferable that each substituent is independently a substituent (hereafter this substituent is sometimes referred to as "the substituent R^{A}") selected from the group consisting of -R¹ (excluding the case of a hydrogen atom), - OR², -SR³, -OCOR⁴, -COOR⁵, -SiR⁶R⁷R⁸, halogen atoms, groups containing the crosslinking group (1), groups containing the crosslinking group (2), and groups containing a polymerizable functional group. Each of R¹ to R⁸ independently represents a hydrogen atom, an alkyl group, an aryl group or a heteroaryl group. The alkyl group may be further substituted with an aryl group and/or a heteroaryl group. The aryl group may be further substituted with an alkyl group and/or a heteroaryl group. The heteroaryl group may be further substituted with an alkyl group and/or an aryl group. R is preferably a hydrogen atom, an alkyl group, an aryl group, or an alkyl-substituted aryl group.

Ar represents an arylene group or a heteroarylene group. Ar is preferably an arylene group, and more preferably a phenylene group. Ar may have a substituent, and examples of the substituent include the substituent R^{A} described above, with the substituent R^{E} described below being preferred, and the substituent R^{B} described below being more preferred.

In the present disclosure, an alkyl group may be a linear, branched or cyclic alkyl group. The linear, branched or cyclic alkyl group is an atom grouping in which one hydrogen atom has been removed from a linear or branched saturated hydrocarbon, or an atom grouping in which one hydrogen atom has been removed from a cyclic saturated hydrocarbon. The alkyl group preferably has 1 to 22 carbon atoms. An aryl group is an atom grouping in which one hydrogen atom has been removed from an aromatic hydrocarbon ring. The aryl group preferably has 6 to 30 carbon atoms. A heteroaryl group is an atom grouping in which one hydrogen atom has been removed from an aromatic heterocycle. The heteroaryl group preferably has 2 to 30 carbon atoms. An arylene group is an atom grouping in which two hydrogen atoms have been removed from an aromatic hydrocarbon ring. The arylene group preferably has 6 to 30 carbon atoms. A heteroarylene group is an atom grouping in which two hydrogen atoms have been removed from an aromatic heterocycle. The heteroarylene group preferably has 2 to 30 carbon atoms.

In one embodiment, the structural unit L may contain at least one of the crosslinking group (1) and the crosslinking group (2), provided the effects are not impaired. Further, in one embodiment, from the viewpoint of obtaining a superior improvement in characteristics, the structural unit L does not contain both the crosslinking group (1) and the crosslinking group (2).

### (Structural Unit T)

The structural unit T is a monovalent structural unit that forms a terminal portion of the charge transport polymer. The structural unit T may be a structural unit that has charge transport properties. The charge transport polymer has at least one structural unit T1 and at least one structural unit T2. In those cases where the charge transport polymer has more than two terminals, the charge transport polymer may also have a structural unit T3. There are no particular limitations on the structural unit T3.

### (Structural Unit T1)

The structural unit T1 is a structural unit containing a crosslinking group represented by formula (1). The charge transport polymer may have only one type of the structural unit T1, or may have two or more types. The structural unit T1 may contain only one crosslinking group (1), or may contain two or more crosslinking groups (1). In the case of two or more crosslinking groups (1), the two or more groups may be of the same type, or of different types.

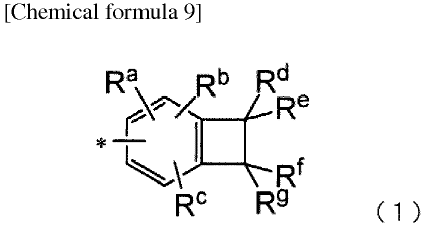

Each of R^{a} to R^{g} independently represents a hydrogen atom or a substituent. Examples of the substituent include a substituent (hereafter this substituent is sometimes referred to as "the substituent R^{B}") selected from the group consisting of -R¹, -OR², -SR³, -OCOR⁴, -COOR⁵, -SiR⁶R⁷R⁸ and halogen atoms described above in relation to the structural unit L.

In one embodiment, from the viewpoint of obtaining satisfactory crosslinking, R^{a} to R^{g} are all hydrogen atoms.

In one embodiment, the structural unit T1 may be a structure represented by formula (1). In other words, the crosslinking group (1) may be the structural unit T1. In another embodiment, the structural unit T1 may be a structural unit having a substituted or unsubstituted aromatic ring structure, and the crosslinking group (1) bonded to this aromatic ring structure either directly or via a divalent linking group. In the latter case, the structural unit T1 has a bonding site with another structural unit on the aromatic ring structure. Examples of the divalent linking group include substituted or unsubstituted alkylene groups, an ether linkage, a carbonyl linkage, substituted or unsubstituted aromatic ring groups, and groups in which two or more of these groups are bonded together. Examples of substituents that the aromatic ring structure, the alkylene group or the aromatic ring group may have include a substituent (hereafter this substituent is sometimes referred to as "the substituent R^{C}") selected from the group consisting of -R¹, -OR², -SR³, -OCOR⁴, -COOR⁵, -SiR⁶R⁷R⁸, halogen atoms, groups containing the crosslinking group (1), and groups containing a polymerizable functional group described above in relation to the structural unit L. Further, the alkylene group may be linear, branched or cyclic.

In the present disclosure, an alkylene group may be a linear, branched or cyclic alkylene group. A linear, branched or cyclic alkylene group is either an atom grouping in which two hydrogen atoms have been removed from a linear or branched saturated hydrocarbon, or an atom grouping in which two hydrogen atoms have been removed from a cyclic saturated hydrocarbon.

In the present disclosure, an "aromatic ring" describes a ring that exhibits aromaticity. The aromatic ring may be an aromatic hydrocarbon such as benzene, naphthalene, anthracene, tetracene, fluorene or phenanthrene, or may be an aromatic heterocycle such as pyridine, pyrazine, quinoline, isoquinoline, acridine, phenanthroline, furan, pyrrole, thiophene, carbazole, oxazole, oxadiazole, thiadiazole, triazole, benzoxazole, benzoxadiazole, benzothiadiazole, benzotriazole or benzothiophene.

Further, the aromatic ring may be single ring such as benzene, a condensed polycyclic aromatic hydrocarbon in which the rings are condensed together such as naphthalene, or a condensed polycyclic aromatic heterocycle in which the rings are condensed together such as quinoline.

The aromatic ring may also be a structure in which two or more independent rings selected from among single ring or condensed ring structures are bonded together, such as biphenyl, terphenyl or triphenylbenzene.

The structural unit T1 may be represented, for example, by formula (3) shown below.
[Chemical formula 10]

*(̵T1) (3)

T1 is a structural unit containing the crosslinking group (1).

An example of a structural unit represented by formula (3) is shown below. The structural unit T1 is not limited to the following example.

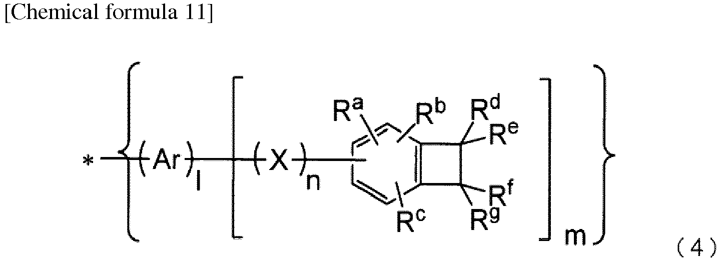

Ar represents a substituted or unsubstituted aromatic ring, X represents a divalent linking group, each of R^{a} to R^{g} independently represents a hydrogen atom or a substituent, and 1 to m represent integers, wherein 1 is 0 or 1, n is 0 or 1, and m is 1 or greater. The upper limit for m is determined in accordance with the structure of Ar and the value of 1.

Examples of the substituent which the aromatic ring may have include the substituent R^{C} described above, whereas when at least one of R^{a} to R^{g} is a substituent, examples of the substituent include the substituent R^{B} described above.

An example of a structural unit represented by formula (4) is shown below. The structural unit T1 is not limited to the following example.

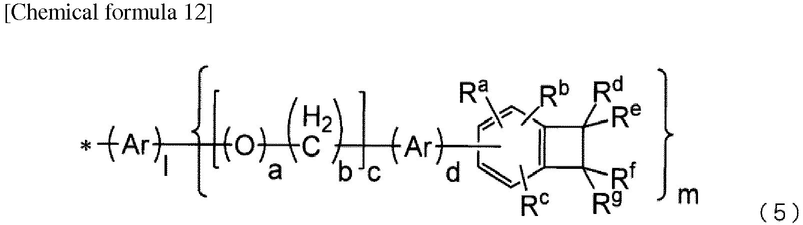

Ar represents a substituted or unsubstituted aromatic ring, each of R^{a} to R^{g} independently represents a hydrogen atom or a substituent, and l and m represent integers, wherein 1 is 0 or 1, and m is 1 or greater. The upper limit for m is determined in accordance with the structure of Ar and the value of 1. Further, a to d represents integers, wherein a is 0 or 1, b is from 0 to 20, c is from 0 to 5, and d is from 0 to 3.

Examples of the substituent which the aromatic ring may have include the substituent R^{C} described above, whereas when at least one of R^{a} to R^{g} is a substituent, examples of the substituent include the substituent R^{B} described above.

An example of a structural unit represented by formula (5) is shown below. The structural unit T1 is not limited to the following example.

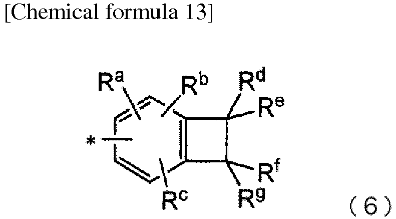

Each of R^{a} to R^{g} independently represents a hydrogen atom or a substituent.

When at least one of R^{a} to R^{g} is a substituent, examples of the substituent include the substituent R^{B} described above.

An example of a structural unit represented by formula (5) is shown below. The structural unit T1 is not limited to the following example.

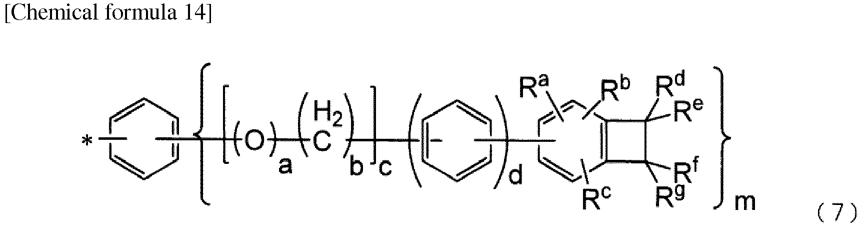

Each of R^{a} to R^{g} independently represents a hydrogen atom or a substituent, m represents an integer of 1 to 5, and a to d represent integers, wherein a is 0 or 1, b is from 0 to 20, c is from 0 to 5, and d is from 0 to 3.

When at least one of R^{a} to R^{g} is a substituent, examples of the substituent include the substituent R^{B} described above.

Specific examples of the structural unit T1 are shown below, but the structural unit T1 is not limited to the following specific examples.

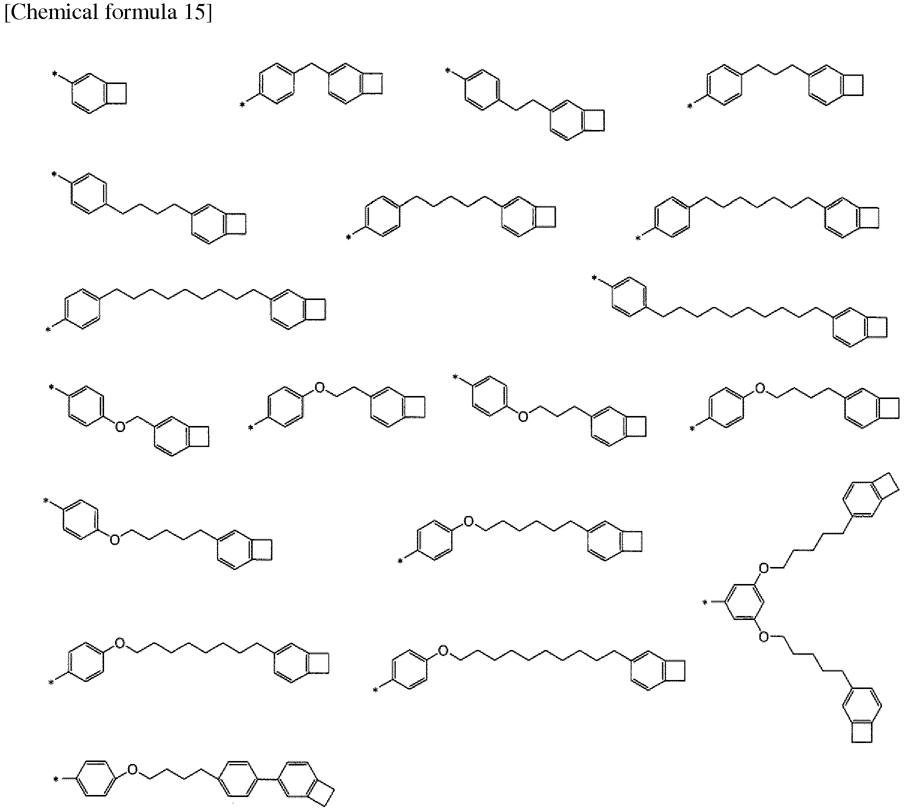

### (Structural Unit T2)

The structural unit T2 is a structural unit containing a crosslinking group represented by formula (2). The charge transport polymer may have only one type of the structural unit T2, or may have two or more types. The structural unit T2 may contain only one crosslinking group (2), or may contain two or more crosslinking groups (2). In the case of two or more crosslinking groups (2), the two or more groups may be of the same type, or of different types.

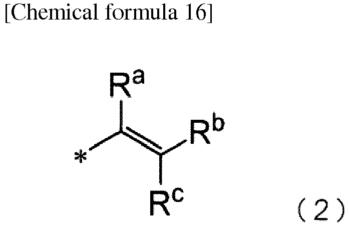

Each of R^{a} to R^{c} independently represents a hydrogen atom or a substituent. Examples of the substituent include the substituent R^{B}.

In one embodiment, from the viewpoint of obtaining satisfactory crosslinking, preferred structures include a structure in which R^{a} to R^{c} are all hydrogen atoms; a structure in which R^{a} and R^{b} are hydrogen atoms and R^{c} is a methyl group; a structure in which R^{a} and R^{b} are hydrogen atoms and R^{c} is a phenyl group; and a structure in which R^{a} is a methyl group and R^{b} and R^{c} are hydrogen atoms.

In one embodiment, the structural unit T2 may be a structure represented by formula (2). In other words, the crosslinking group (2) may be the structural unit T2. In another embodiment, the structural unit T2 may be a structural unit having a substituted or unsubstituted aromatic ring structure, and the crosslinking group (2) bonded to this aromatic ring structure either directly or via a divalent linking group. In the latter case, the structural unit T2 has a bonding site with another structural unit on the aromatic ring structure. Examples of the divalent linking group include substituted or unsubstituted alkylene groups, an ether linkage, a carbonyl linkage, substituted or unsubstituted aromatic ring groups, and groups in which two or more of these groups are bonded together. Examples of substituents that the aromatic ring structure, the alkylene group or the aromatic ring group may have include a substituent (hereafter this substituent is sometimes referred to as "the substituent R^{D}") selected from the group consisting of -R¹, -OR², -SR³, -OCOR⁴, -COOR⁵, -SiR⁶R⁷R⁸, halogen atoms, groups containing the crosslinking group (2), and groups containing a polymerizable functional group described above in relation to the structural unit L. Further, the alkylene group may be linear, branched or cyclic.

The structural unit T2 may be represented, for example, by formula (8) shown below.
[Chemical formula 17]

*(̵T2) (8)

T2 is a structural unit containing the crosslinking group (2).

An example of a structural unit represented by formula (8) is shown below. The structural unit T2 is not limited to the following example.

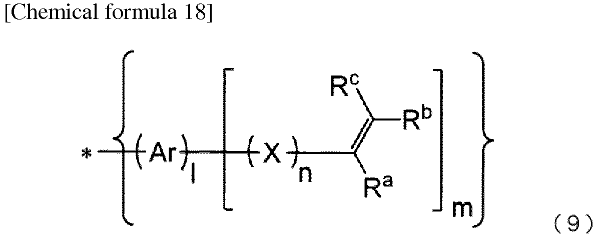

Ar represents a substituted or unsubstituted aromatic ring, X represents a divalent linking group, each of R^{a} to R^{c} independently represents a hydrogen atom or a substituent, and 1 to m represent integers, wherein 1 is 0 or 1, n is 0 or 1, and m is 1 or greater. The upper limit for m is determined in accordance with the structure of Ar and the value of 1.

Examples of the substituent which the aromatic ring may have include the substituent R^{D} described above, whereas when at least one of R^{a} to R^{c} is a substituent, examples of the substituent include the substituent R^{B} described above.

An example of a structural unit represented by formula (9) is shown below. The structural unit T2 is not limited to the following example.

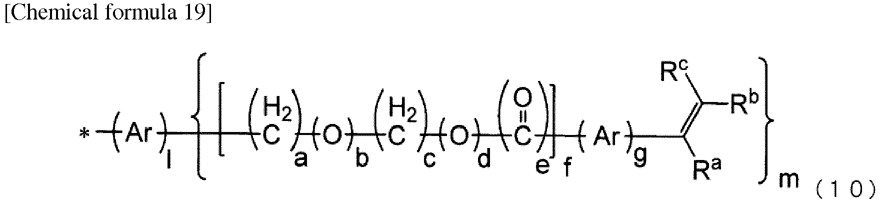

Ar represents a substituted or unsubstituted aromatic ring, each of R^{a} to R^{c} independently represents a hydrogen atom or a substituent, and l and m represents integers, wherein 1 is 0 or 1, and m is 1 or greater. The upper limit for m is determined in accordance with the structure of Ar and the value of 1. Further, a to g represent integers, wherein a is from 0 to 20, b is 0 or 1, c is from 0 to 20, d is 0 or 1, e is 0 or 1, f is from 0 to 5, and g is 0 or 1.

Examples of the substituent which the aromatic ring may have include the substituent R^{D} described above, whereas when at least one of R^{a} to R^{c} is a substituent, examples of the substituent include the substituent R^{B} described above.

An example of a structural unit represented by formula (10) is shown below. The structural unit T2 is not limited to the following example.

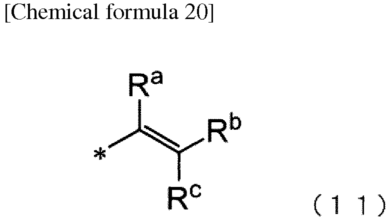

Each of R^{a} to R^{c} independently represents a hydrogen atom or a substituent.

When at least one of R^{a} to R^{c} is a substituent, examples of the substituent include the substituent R^{B} described above.

An example of a structural unit represented by formula (10) is shown below. The structural unit T2 is not limited to the following example.

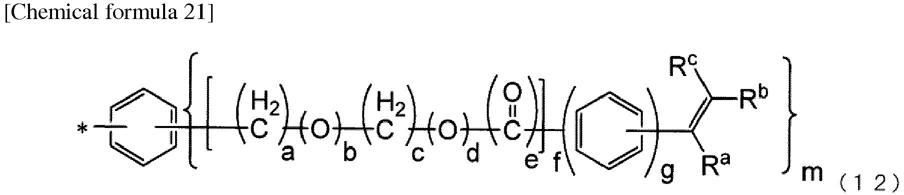

Each of R^{a} to R^{c} independently represents a hydrogen atom or a substituent, m represents an integer of 1 to 5, and a to g represents integers, wherein a is from 0 to 20, b is 0 or 1, c is from 0 to 20, d is 0 or 1, e is 0 or 1, f is from 0 to 5, and g is 0 or 1.

When at least one of R^{a} to R^{c} is a substituent, examples of the substituent include the substituent R^{B} described above.

Specific examples of the structural unit T2 are shown below, but the structural unit T1 is not limited to the following specific examples.

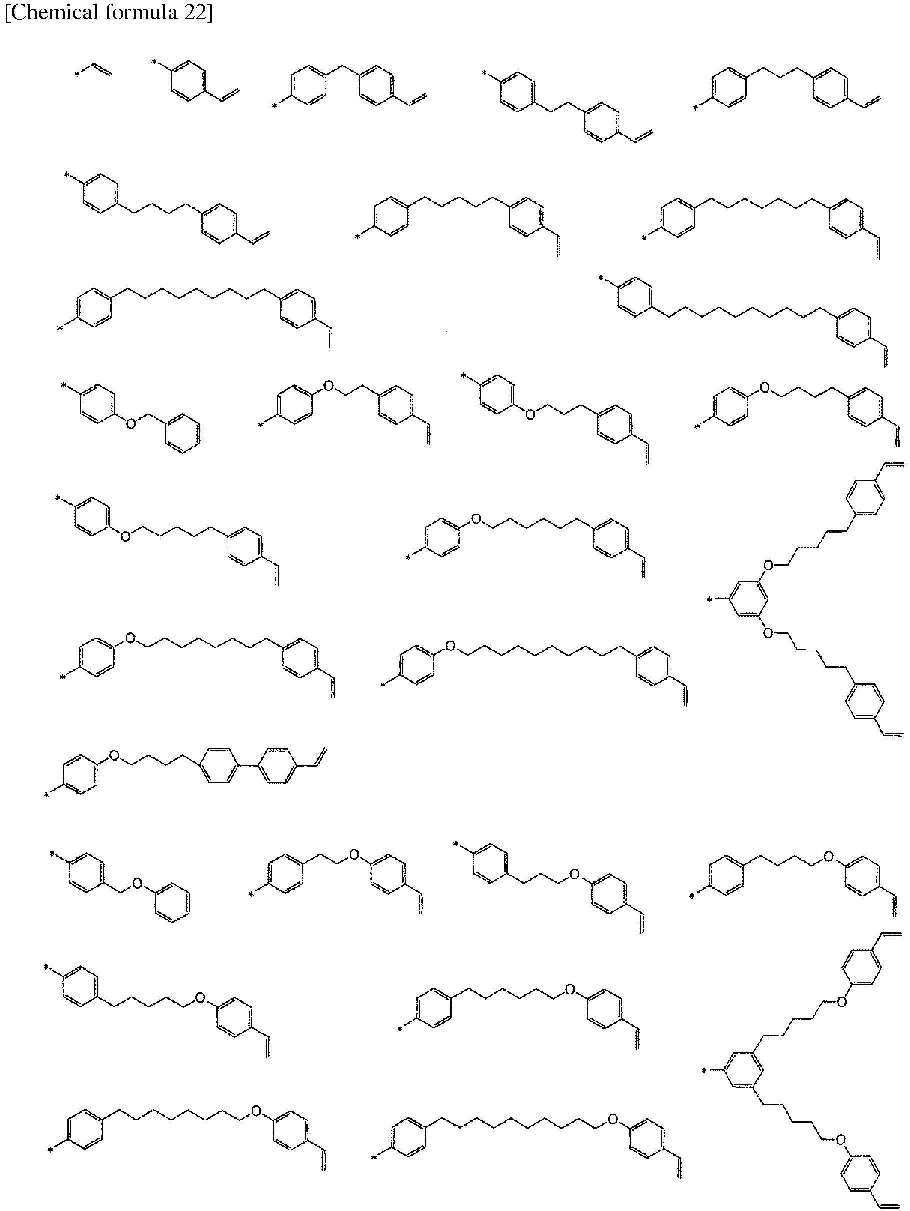

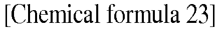

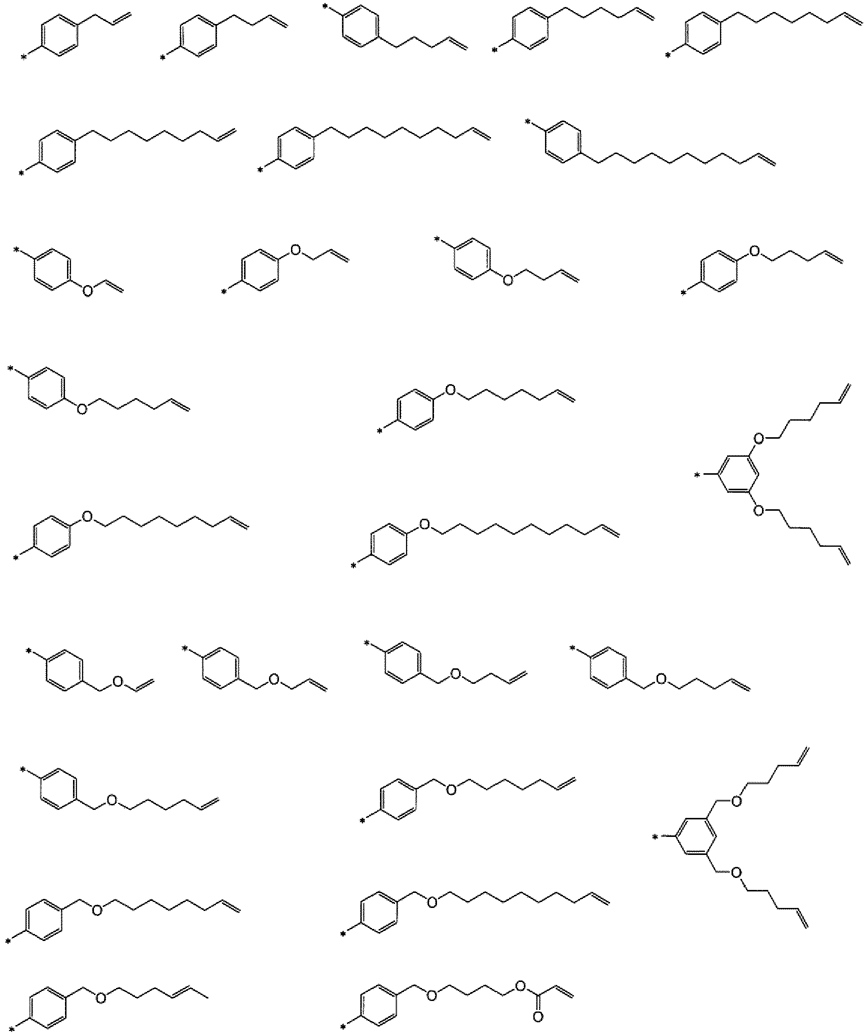

### (Structural Unit T3)

The structural unit T3 is a structural unit that is different from the structural unit T1 and the structural unit T2. The structural unit T3 does not contain the crosslinking group (1), and also does not contain the crosslinking group (2). In those cases where the charge transport polymer includes a structural unit T3, the charge transport polymer may have only one type of structural unit T3, or may have two or more types.

There are no particular limitations on the structural unit T3, which, for example, may contain an aromatic ring structure. The structural unit preferably contains at least one type of structure selected from the group consisting of substituted or unsubstituted aromatic hydrocarbon structures and substituted or unsubstituted aromatic heterocyclic structures. In one embodiment, from the viewpoint of imparting durability without impairing the charge transport properties, the structural unit T3 is preferably a substituted or unsubstituted aromatic hydrocarbon structure, and is more preferably a substituted or unsubstituted benzene structure. Further, in one embodiment, the structural unit T3 may be a polymerizable structure (in other words, may be a polymerizable functional group such as a pyrrolyl group). The structural unit T3 may have a similar structure to the structural unit L, or may have a different structure. However, when the structural unit T3 has a similar structure to the structural unit L, the structural unit L is converted to a monovalent form to generate the structural unit T. In those cases where any of these structures have a substituent, the substituent may be a substituent (hereafter this substituent is sometimes referred to as "the substituent R^{E}") selected from the group consisting of -R¹, -OR², -SR³, -OCOR⁴, -COOR⁵, -SiR⁶R⁷R⁸, halogen atoms, and groups containing a polymerizable substituent described above in relation to the structural unit L.

Specific examples of the structural unit T3 include structural units represented by formula (13) shown below. The structural unit T3 is not limited to the following structure.

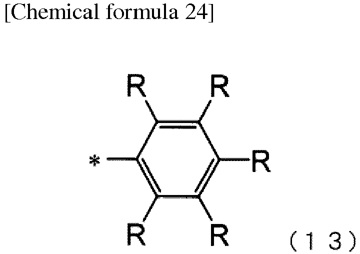

R represents a hydrogen atom or a substituent. Examples of the substituent include the substituent R^{E} described above. In those cases where, in addition to the crosslinking group (1) and the crosslinking group (2) at the terminals, the charge transport polymer also has another polymerizable functional group at a terminal, it is preferable that at least one of the R groups is a group containing a polymerizable functional group.

### (Proportions of Structural Units T1, T2 and T3)

From the viewpoint of imparting favorable curability, the proportion of the structural unit T1 among all the structural units T in the charge transport polymer, based on the total number of all the structural units T, is preferably at least 0.1 mol%, more preferably at least 0.2 mol%, and even more preferably 0.3 mol% or greater. In particular, a proportion of at least 1 mol% is preferred, and a proportion of at least 2 mol% is more preferred. The charge transport polymer need only have at least one structural unit T2, and there are no particular limitations. Accordingly, the upper limit for the proportion of the structural unit T1 is less than 100 mol%. If consideration is given to the inclusion of other structural units T, then the proportion of the structural unit T1 may be set, for example, to not more than 80 mol%, not more than 50 mol%, not more than 20 mol%, not more than 10 mol%, or 8 mol% or less. This proportion among all the structural units T can be determined, for example, from the ratio (molar ratio) between the amounts added of the monomers corresponding with the various structural units T during the synthesis of the charge transport polymer.

From the viewpoint of imparting favorable curability, the proportion of the structural unit T2 among all the structural units T in the charge transport polymer, based on the total number of all the structural units T, is preferably at least 0.1 mol%, more preferably at least 0.2 mol%, and even more preferably 0.3 mol% or greater. In particular, a proportion of at least 1 mol% is preferred, and a proportion of at least 2 mol% is more preferred. The charge transport polymer need only have at least one structural unit T1, and there are no particular limitations. Accordingly, the upper limit for the proportion of the structural unit T2 is less than 100 mol%. If consideration is given to the inclusion of other structural units T, then the proportion of the structural unit T2 may be set, for example, to not more than 80 mol%, not more than 50 mol%, not more than 20 mol%, not more than 10 mol%, or 8 mol% or less. This proportion among all the structural units T can be determined, for example, from the ratio (molar ratio) between the amounts added of the monomers corresponding with the various structural units T during the synthesis of the charge transport polymer.

In those cases where the charge transport polymer has a structural unit T3, considering the introduction of the structural unit T1 and the structural unit T2, the proportion of the structural unit T3 among all the structural units T in the charge transport polymer, based on the total number of all the structural units T, is preferably not more than 99.8 mol%, more preferably not more than 99.6 mol%, and even more preferably 99.4 mol% or less. There are no particular limitations on the lower limit, but if consideration is given to the introduction of polymerizable functional groups, and the introduction of substituents for improving properties such as the film formability and the wettability, then, for example, a proportion of at least 5 mol% is used.

### (Structural Unit B)

The structural unit B is a trivalent or higher structural unit that forms a branched portion in those cases where the charge transport polymer has a branched structure. From the viewpoint of improving the durability of organic electronic elements, the structural unit B is preferably not higher than hexavalent, and is more preferably either trivalent or tetravalent. The structural unit B is preferably a unit that has charge transport properties. For example, from the viewpoint of improving the durability of organic electronic elements, the structural unit B preferably contains at least one type of structure selected from the group consisting of substituted or unsubstituted aromatic amine structures, substituted or unsubstituted carbazole structures, and substituted or unsubstituted condensed polycyclic aromatic hydrocarbon structures. In those cases where any of these structures has a substituent, examples of the substituent include the substituent R^{A} described above, with the substituent R^{E} described above being preferred, and the substituent R^{B} described above being more preferred.

Specific examples of the structural unit B are shown below. However, the structural unit B is not limited to the following structures.

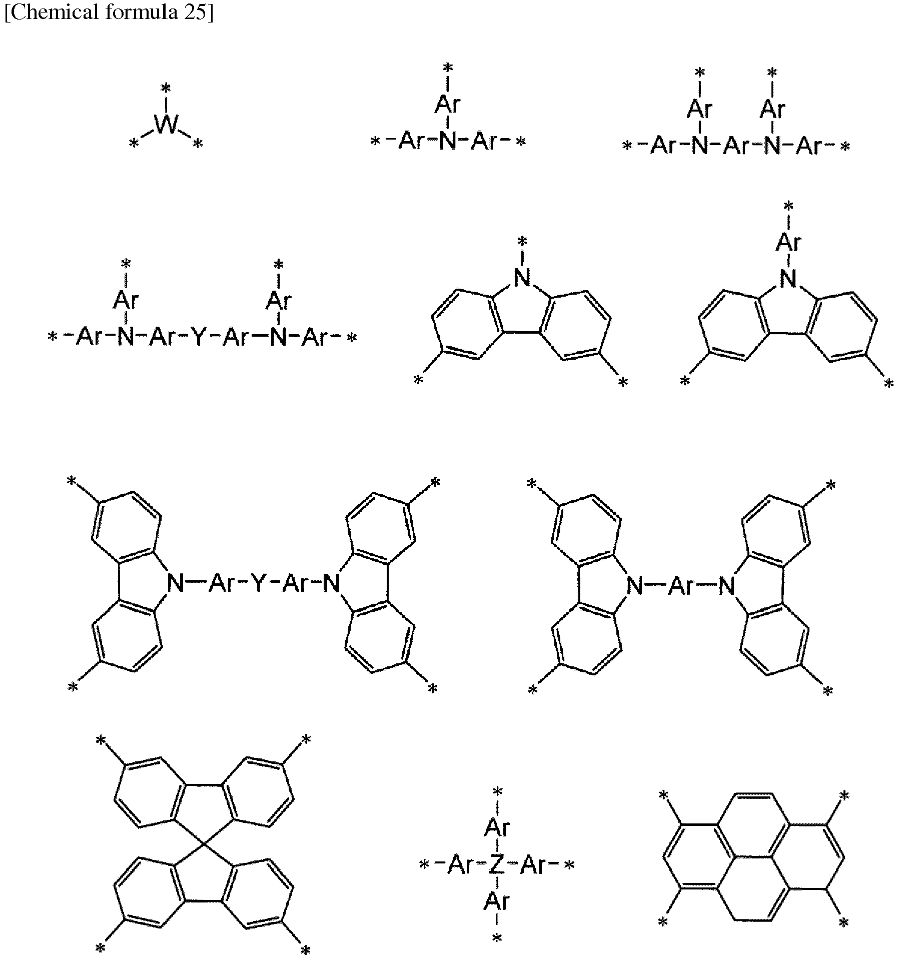

W represents a trivalent linking group, and for example, represents an arenetriyl group or a heteroarenetriyl group. Each Ar independently represents a divalent linking group, and for example, independently represents an arylene group or heteroarylene group. Ar is preferably an arylene group, and is more preferably a phenylene group. Y represents a divalent linking group, and examples include divalent groups in which an additional hydrogen atom has been removed from any of the above R^{B} substituents having one or more hydrogen atoms. Z represents a carbon atom, a silicon atom or a phosphorus atom. In the structural units, the benzene rings and Ar groups may have a substituent, and examples of the substituent include the substituent R^{A} described above in relation to the structural unit L, with the substituent R^{E} described above being preferred, and the substituent R^{B} described above being more preferred.

In the present disclosure, an arenetriyl group is an atom grouping in which three hydrogen atoms have been removed from an aromatic hydrocarbon. The arenetriyl group preferably has 6 to 30 carbon atoms. A heteroarenetriyl is an atom grouping in which three hydrogen atoms have been removed from an aromatic heterocycle. The heteroarenetriyl group preferably has 2 to 30 carbon atoms.

In one embodiment, the structural unit B may contain at least one of the crosslinking group (1) and the crosslinking group (2), provided the effects are not impaired. Further, in another embodiment, from the viewpoint of obtaining a superior improvement in characteristics, the structural unit B does not contain both the crosslinking group (1) and the crosslinking group (2).

### (Polymerizable Functional Group)

In one embodiment, from the viewpoint of enabling the polymer to be cured by a polymerization reaction, thereby changing the degree of solubility in solvents, the charge transport polymer may have at least one polymerizable functional group different from the structure containing the crosslinking group (1) and the structure containing the crosslinking group (2). A "polymerizable functional group" refers to a functional group which is able to form bonds upon the application of heat and/or light.

Examples of the polymerizable functional group include groups having a small ring (including cyclic alkyl groups such as a cyclopropyl group and cyclobutyl group; cyclic ether groups such as an epoxy group (oxiranyl group) and oxetane group (oxetanyl group); diketene groups; episulfide groups; lactone groups; and lactam groups), and heterocyclic groups (such as a furanyl group, pyrrolyl group, thiophenyl group and silolyl group). In those cases where a polymerizable functional group is included, an epoxy group and/or oxetane group is preferred, and from the viewpoints of the reactivity and the characteristics of organic electronic elements, an oxetane group is particularly preferred.

From the viewpoints of increasing the degree of freedom associated with the polymerizable functional group and facilitating the polymerization reaction, the main skeleton of the charge transport polymer and the polymerizable functional group are preferably linked via an alkylene chain. Further, in the case where, for example, an organic layer is to be formed on an electrode, from the viewpoint of enhancing the affinity with hydrophilic electrodes of ITO or the like, the main skeleton and the polymerizable functional group are preferably linked via a hydrophilic chain such as an ethylene glycol chain or a diethylene glycol chain. Moreover, from the viewpoint of simplifying preparation of the monomer used for introducing the polymerizable functional group, the charge transport polymer may have an ether linkage or an ester linkage at the terminal of the alkylene chain and/or the hydrophilic chain, namely, at the linkage site between these chains and the polymerizable functional group, and/or at the linkage site between these chains and the charge transport polymer skeleton. The aforementioned "group containing a polymerizable functional group" includes either a polymerizable functional group itself, or a group containing a combination of a polymerizable functional group and an alkylene chain or the like. The polymerizable functional group may have a substituent such as a linear, branched or cyclic alkyl group. Examples of groups that can be used favorably as this group containing a polymerizable functional group include the groups exemplified in WO 2010/140553.

The polymerizable functional group may be introduced at a terminal of the charge transport polymer (namely, a structural unit T), at a portion other than a terminal (namely, a structural unit L or B), or at both a terminal and a portion other than a terminal. From the viewpoint of the curability, the polymerizable functional group is preferably introduced at least at a terminal (namely, a structural unit T), and from the viewpoint of achieving a combination of favorable curability and charge transport properties, is preferably introduced only at terminals. Further, in those cases where the charge transport polymer is a branched polymer, the polymerizable functional group may be introduced into the main chain of the charge transport polymer, may be introduced within a side chain, or may be introduced within both the main chain and a side chain.

### (Number Average Molecular Weight, Weight Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. Further, from the viewpoints of maintaining favorable solubility in solvents and facilitating the preparation of liquid compositions, the number average molecular weight is preferably not more than 1,000,000, more preferably not more than 100,000, and even more preferably 50,000 or less.

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of liquid compositions, the weight average molecular weight is preferably not more than 1,000,000, more preferably not more than 700,000, and even more preferably 400,000 or less.

The number average molecular weight and the weight average molecular weight can be measured by gel permeation chromatography (GPC) using a calibration curve of standard polystyrenes. The measurement conditions may be set, for example, as follows.
Apparatus:
   High-performance liquid chromatograph "Prominence", manufactured by Shimadzu Corporation
   Feed pump (LC-20AD)
   Degassing unit (DGU-20A)
   Autosampler (SIL-20AHT)
   Column oven (CTO-20A)
   PDA detector (SPD-M20A)
   Refractive index detector (RID-20A)
Columns:
   Gelpack (a registered trademark)
   GL-A160S (product number: 686-1J27)
   GL-A150S (product number: 685-1J27)
   manufactured by Hitachi Chemical Co., Ltd.
Eluent: Tetrahydrofuran (THF) (for HPLC, contains stabilizers), manufactured by Wako Pure Chemical Industries, Ltd.
Flow rate: 1 mL/min
Column temperature: 40°C
Detection wavelength: 254 nm
Molecular weight standards: PStQuick A/B/C, manufactured by Tosoh Corporation

### (Proportions and the like of Structural Units)

In those cases where the charge transport polymer includes a structural unit L, from the viewpoint of obtaining satisfactory charge transport properties, the proportion of the structural unit L, based on the total of all the structural units, is preferably at least 10 mol%, more preferably at least 20 mol%, and even more preferably 30 mol% or higher. Further, if the structural unit T and the optionally introduced structural unit B are taken into consideration, then the proportion of the structural unit L is preferably not more than 95 mol%, more preferably not more than 90 mol%, and even more preferably 85 mol% or less.

From the viewpoint of improving the characteristics of organic electronic elements, or from the viewpoint of suppressing any increase in viscosity and enabling more favorable synthesis of the charge transport polymer, the proportion of the structural unit T contained in the charge transport polymer, based on the total of all the structural units, is preferably at least 5 mol%, more preferably at least 10 mol%, and even more preferably 15 mol% or higher. Further, from the viewpoint of obtaining satisfactory charge transport properties, the proportion of the structural unit T is preferably not more than 60 mol%, more preferably not more than 55 mol%, and even more preferably 50 mol% or less.

In those cases where the charge transport polymer includes a structural unit B, from the viewpoint of improving the durability of organic electronic elements, the proportion of the structural unit B, based on the total of all the structural units, is preferably at least 1 mol%, more preferably at least 5 mol%, and even more preferably 10 mol% or higher. Further, from the viewpoints of suppressing any increase in viscosity and enabling more favorable synthesis of the charge transport polymer, or from the viewpoint of obtaining satisfactory charge transport properties, the proportion of the structural unit B is preferably not more than 50 mol%, more preferably not more than 40 mol%, and even more preferably 30 mol% or less.

From the viewpoint of enabling efficient curing of the charge transport polymer, the combined proportion of the crosslinking group (1), the crosslinking group (2) and the optionally included polymerizable functional group (hereafter, these groups are sometimes jointly referred to as "the polymerizable groups"), based on the total of all the structural units, is preferably at least 0.01 mol%, more preferably at least 0.05 mol%, and even more preferably 0.1 mol% or greater. In particular, from the viewpoint of obtaining satisfactory curability, this proportion is preferably at least 0.5 mol%, more preferably at least 1 mol%, and even more preferably 1.5 mol% or greater. Further, from the viewpoint of obtaining favorable charge transport properties, the proportion of the polymerizable groups is preferably not more than 70 mol%, more preferably not more than 60 mol%, and even more preferably 50 mol% or less. In particular, the proportion is preferably not more than 30 mol%, more preferably not more than 20 mol%, and even more preferably 10 mol% or less. Here, the "proportion of the polymerizable groups" refers to the proportion of structural units having a polymerizable group.

Considering the balance between the charge transport properties, the durability, and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer also includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).

In one embodiment, when the organic electronic material is a hole transport material, from the viewpoint of obtaining superior hole injection properties and hole transport properties, the charge transport polymer preferably has a structural unit containing an aromatic amine structure and/or a structural unit containing a carbazole structure as a main structural unit. From this viewpoint, the total proportion of structural units containing an aromatic amine structure and/or structural units containing a carbazole structure (in the case the polymer includes only one of these structural units, the proportion of the total number of that structural unit, or in the case the polymer includes both structural units, the combined total of both structural units), based on the total number of all the structural units L and the structural units B within the charge transport polymer, is preferably at least 40 mol%, more preferably at least 45 mol%, and even more preferably 50 mol% or greater. This proportion of the total number of structural units containing an aromatic amine structure and/or structural units containing a carbazole structure may be 100 mol%. The aromatic amine structure and the carbazole structure may each be either substituted or unsubstituted.

The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the ¹H-NMR spectrum of the charge transport polymer. In terms of simplicity, if the amount added of the monomer is clear, then the value determined using the amount added of the monomer is preferably employed.

From the viewpoint of contributing to a change in the degree of solubility, the polymerizable groups are preferably included in the charge transport polymer in a large amount. On the other hand, from the viewpoint of not impeding the charge transport properties, the amount included in the charge transport polymer is preferably kept small. The amount of the polymerizable groups may be set as appropriate with due consideration of these factors.

For example, from the viewpoint of obtaining a satisfactory change in the degree of solubility, the number of polymerizable groups per molecule of the charge transport polymer is at least 2, preferably at least 3, and more preferably 4 or greater. Further, from the viewpoint of maintaining good charge transport properties, the number of polymerizable groups is preferably not more than 1,000, and more preferably 500 or fewer.

The number of polymerizable groups can be determined as an average value using the amount added of the polymerizable groups (for example, the amount added of monomers having a polymerizable group) and the amounts added of the monomers corresponding with the various structural units during synthesis of the charge transport polymer, and the weight average molecular weight of the charge transport polymer and the like. Further, the number of polymerizable groups can also be calculated as an average value using the ratio between the integral of the signals attributable to the polymerizable groups and the integral of the total spectrum in the ¹H-NMR (nuclear magnetic resonance) spectrum of the charge transport polymer, and the weight average molecular weight of the charge transport polymer and the like. In terms of simplicity, if the amounts added of the various components are clear, then the value determined using these amounts is preferably employed. The numbers of the crosslinking group (1), the crosslinking group (2) and the polymerizable functional group may be determined in a similar manner to that described above.

### (Production Method)

The charge transport polymer can be produced by various synthesis methods, and there are no particular limitations. In one embodiment, the charge transport polymer is a copolymer of monomers including at least a difunctional monomer containing a structural unit having charge transport properties, a monofunctional monomer T1 containing the crosslinking group (1), and a monofunctional monomer T2 containing the crosslinking group (2). Further, in another embodiment, the charge transport polymer is a copolymer of monomers including at least a difunctional monomer containing a structural unit having hole transport properties, a monofunctional monomer T1 containing the crosslinking group (1), and a monofunctional monomer T2 containing the crosslinking group (2). In either embodiment, the monomers may also include a trifunctional or higher polyfunctional monomer.

In one embodiment, the charge transport polymer is a copolymer of monomers including at least a trifunctional or higher polyfunctional monomer containing a structural unit having charge transport properties, a monofunctional monomer T1 containing the crosslinking group (1), and a monofunctional monomer T2 containing the crosslinking group (2). Further, in another embodiment, the charge transport polymer is a copolymer of monomers including at least a trifunctional or higher polyfunctional monomer containing a structural unit having hole transport properties, a monofunctional monomer T1 containing the crosslinking group (1), and a monofunctional monomer T2 containing the crosslinking group (2). In either embodiment, the monomers may also include a difunctional monomer.

A difunctional monomer is a monomer having two functional groups that can react to form bonds in the copolymerization reaction, a monofunctional monomer is a monomer having one functional group that can react to form a bond in the copolymerization reaction, and a trifunctional or higher monomer is a monomer having three or more functional groups that can react to form bonds in the copolymerization reaction.

Examples of methods that can be used to obtain the copolymer include conventional coupling reactions such as the Suzuki coupling, Negishi coupling, Sonogashira coupling, Stille coupling and Buchwald-Hartwig coupling reactions. The Suzuki coupling is a reaction in which, for example, a cross-coupling reaction is initiated between an aromatic boronic acid derivative and an aromatic halide using a Pd catalyst. By using a Suzuki coupling, the charge transport polymer can be produced easily by bonding together the desired aromatic rings.

According to one embodiment, the structural unit L, the structural unit B and the structural unit T are all structural units derived from monomers used for introducing each of the structural units via a copolymerization reaction.

In the coupling reaction, a Pd(0) compound, Pd(II) compound, or Ni compound or the like may be used as a catalyst. Further, a catalyst species generated by mixing a precursor such as tris(dibenzylideneacetone)dipalladium(0) or palladium(II) acetate with a phosphine ligand may also be used.

Examples of monomers that may be used in the copolymerization reaction include those shown below.

### <<Monomer L>>

[Chemical formula 26] R¹-L-R¹

### <<Monomer B>>

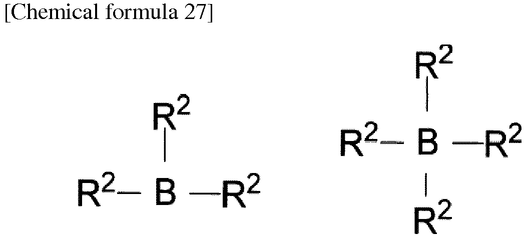

### <<Monomer T>>

[Chemical formula 28] T-R³

In the above formulas, L represents a structural unit L, B represents a structural unit B, and T represents a structural unit T. R¹ to R³ represent functional groups between which mutual bonds can be formed, and preferably each independently represent one type of group selected from the group consisting of a boronic acid group, boronate ester groups and halogen groups. The monomer T includes at least a monomer T1 having the structural unit T1 as "T" and a monomer T2 having the structural unit T2 as "T". The monomer L is an example of a difunctional monomer, the monomer B is an example of a trifunctional or higher polyfunctional monomer, and the monomer T is an example of a monofunctional monomer.

These monomers may be synthesized using conventional methods. Further, these monomers can also be obtained, for example, from Tokyo Chemical Industry Co., Ltd., or Sigma-Aldrich Japan Co., Ltd. or the like.

The method for producing the charge transport polymer is not limited to the methods mentioned above, and the charge transport polymer may also be produced, for example, by introducing the crosslinking group (1) and the crosslinking group (2) into a commercially available polymer with charge transport properties.

### [Dopant]

The organic electronic material may also contain a dopant. There are no particular limitations on the dopant, provided it is a compound that yields a doping effect upon addition to the organic electronic material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably used, whereas to improve the electron transport properties, n-type doping is preferably used. The dopant used in the organic electronic material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and π-conjugated compounds. Specific examples include Lewis acids such as FeCl₃, PF₅, AsF₅, SbF₅, BF₅, BCl₃ and BBr₃; protonic acids, including inorganic acids such as HF, HCl, HBr, HNO₅, H₂SO₄ and HClO₄, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, TiCl₄, ZrCl₄, HfCl₄, NbF₅, AlCl₃, NbCl₅, TaCl₅ and MoF₅; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, AsF₆⁻ (hexafluoroarsenate ion), BF₄⁻ (tetrafluoroborate ion) or PF₆⁻ (hexafluorophosphate ion), and salts having a conjugate base of an aforementioned protonic acid as an anion; halogen compounds such as Cl₂, Br₂, I₂, ICl, ICl₃, IBr and IF; and π-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Lewis acids, ionic compounds, and π-conjugated compounds and the like are preferred.

The dopants used in n-type doping are electron-donating compounds, and examples include alkali metals such as Li and Cs; alkaline earth metals such as Mg and Ca; salts of alkali metals and/or alkaline earth metals such as LiF and Cs₂CO₃; metal complexes; and electron-donating organic compounds.

In order to make it easier to change the degree of solubility of the organic layer, it is preferable that a compound that can function as a polymerization initiator for the polymerizable functional group is used as the dopant. Examples of materials that combine a function as a dopant and a function as a polymerization initiator include the ionic compounds described above.

### [Other Optional Components]

The organic electronic material may also include other polymers or the like.

### [Contents]

From the viewpoint of obtaining favorable charge transport properties, the amount of the charge transport polymer, relative to the total mass of the organic electronic material, is preferably at least 50% by mass, more preferably at least 70% by mass, and even more preferably 80% by mass or greater. The amount may be 100% by mass.

When a dopant is included, from the viewpoint of improving the charge transport properties of the organic electronic material, the amount of the dopant relative to the total mass of the organic electronic material is preferably at least 0.01% by mass, more preferably at least 0.1% by mass, and even more preferably 0.5% by mass or greater. Further, from the viewpoint of maintaining favorable film formability, the amount of the dopant relative to the total mass of the organic electronic material is preferably not more than 50% by mass, more preferably not more than 30% by mass, and even more preferably 20% by mass or less.

### [Polymerization Initiator]

According to one embodiment, the organic electronic material may contain a polymerization initiator, but the organic electronic material undergoes a satisfactory polymerization reaction even when the material does not include a polymerization initiator. In those cases where a polymerization initiator is included, a conventional radical polymerization initiator, cationic polymerization initiator, or anionic polymerization initiator or the like may be used. From the viewpoint of simplifying preparation of liquid compositions, the use of a material that combines a function as a dopant and a function as a polymerization initiator is preferred. Examples of polymerization initiators that also exhibit a function as a dopant include the ionic compounds mentioned above. Examples of the ionic compound include salts having a perfluoro anion, and specific examples include salts of a perfluoro anion and an iodonium or ammonium ion (for example, the compounds shown below).

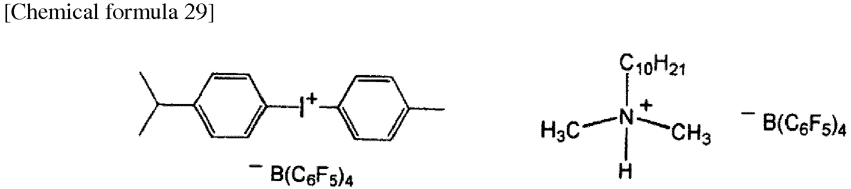

In those cases where the organic electronic material contains a polymerization initiator, the amount of the polymerization initiator, based on the weight of the polymer, is preferably from 0.1 to 10.0% by mass, more preferably from 0.2 to 5.0% by mass, and even more preferably from 0.5 to 3.0% by mass.

### <Liquid Composition>

In one embodiment, a liquid composition contains the organic electronic material described above and a solvent capable of dissolving or dispersing the material. This liquid composition can be used favorably as a liquid composition. By using the liquid composition, an organic layer can be formed easily using a simple coating method. The liquid composition can be used favorably as an ink composition.

### [Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Preferred solvents include aromatic hydrocarbons, aliphatic esters, aromatic esters, aliphatic ethers, and aromatic ethers and the like.

### [Additives]

The liquid composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

### [Contents]

The amount of the solvent in the liquid composition can be determined with due consideration of the use of the composition in various application methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

### <Organic Layer>

According to one embodiment, an organic layer is a layer formed using the organic electronic material described above or the liquid composition described above. By using the liquid composition, the organic layer can be formed favorably by a coating method. Examples of the coating method include conventional methods such as spin coating methods; casting methods; dipping methods; plate-based printing methods such as relief printing, intaglio printing, offset printing, lithographic printing, relief reversal offset printing, screen printing and gravure printing; and plateless printing methods such as inkjet methods. When the organic layer is formed by a coating method, the organic layer (coating layer) obtained following coating may be dried using a hot plate or an oven to remove the solvent.

The degree of solubility of the organic layer may be changed by using light irradiation or a heat treatment or the like to cause a polymerization reaction (crosslinking reaction) of the charge transport polymer. By stacking organic layers having changed degrees of solubility, multilayering of an organic electronic element can be performed with ease. There are no particular limitations on the means used for initiating or progressing the polymerization reaction, and any means that enable polymerization of the polymerizable groups may be used, including application of heat, light, microwaves, other radiation, or an electron beam or the like. Light irradiation and/or a heat treatment is preferred, and a heat treatment is particularly desirable. In the case of light irradiation, the conditions are preferably set to ensure that the insolubilization reaction proceeds satisfactorily, and for example, the irradiation is performed for at least 0.1 seconds, but preferably for not more than 10 hours.

The heat treatment preferably involves heating at a temperature at least as high as the boiling point of the solvent contained in the liquid composition. Heating is preferably performed at a temperature of at least 120°C but not more than 410°C, more preferably at a temperature of at least 125°C but mot more than 350°C, and even more preferably at a temperature of at least 130°C but not more than 250°C.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing electrical resistance, the thickness of the organic layer is preferably not more than 300 nm, more preferably not more than 200 nm, and even more preferably 100 nm or less.

According to one embodiment, the organic electronic material is contained in the organic layer either as the organic electronic material itself, or in the form of a derivative derived from the organic electronic material such as a polymerization product, reaction product or decomposition product.

### <Organic Electronic Element>

According to one embodiment, an organic electronic element has at least the organic layer described above. Examples of the organic electronic element include an organic EL element, an organic photoelectric conversion element, and an organic transistor. The organic electronic element preferably has at least a structure in which the organic layer is disposed between a pair of electrodes (an anode and a cathode).

### [Organic EL Element]

According to one embodiment, an organic EL element has at least the organic layer described above. The organic EL element typically includes a substrate, an anode, a light-emitting layer and a cathode, and if necessary, may also have other functional layers such as a hole injection layer, electron injection layer, hole transport layer and electron transport layer. Each layer may be formed by a vapor deposition method, or by a coating method. The organic EL element preferably has the organic layer as the light-emitting layer or as another functional layer, more preferably has the organic layer as a functional layer, and even more preferably has the organic layer as at least one of a hole injection layer and a hole transport layer.

An example of one embodiment is an organic electroluminescent element containing at least a substrate, an anode, a hole injection layer, a hole transport layer, a light-emitting layer and a cathode, wherein at least one layer selected from the group consisting of the hole injection layer, the hole transport layer and the light-emitting layer is the organic layer described above. Further, another embodiment is an organic electroluminescent element containing at least a substrate, an anode, a hole injection layer, a hole transport layer, a light-emitting layer, an electron transport layer, an electron injection layer and a cathode, wherein at least one layer selected from the group consisting of the hole injection layer, the hole transport layer and the light-emitting layer is the organic layer described above.

FIG. 1 is a cross-sectional schematic view illustrating one example of the organic EL element. The organic EL element in FIG. 1 is an element with a multilayer structure, and has a substrate 8, an anode 2, a hole injection layer 3 and a hole transport layer 6 each formed from the organic layer described above, a light-emitting layer 1, an electron transport layer 7, an electron injection layer 5 and a cathode 4 provided in that order. Each of these layers is described below.

In FIG. 1, the hole injection layer 3 and the hole transport layer 6 are organic layers formed using the organic electronic material described above, but the organic EL element is not limited to this type of structure, and another organic layer may be an organic layer formed using the organic electronic material described above.

### [Light-Emitting Layer]

Examples of materials that can be used for forming the light-emitting layer include light-emitting materials such as low-molecular weight compounds, polymers, and dendrimers and the like. Polymers exhibit good solubility in solvents, meaning they are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Specific examples of Ir complexes include FIr(pic) (iridium(III) bis[(4,6-difluorophenyl)-pyridinato-N,C²]picolinate) which emits blue light, Ir(ppy)₃ (fac-tris(2-phenylpyridine)iridium) which emits green light, and (btp)₂Ir(acac) (bis[2-(2'-benzo[4,5-α]thienyl)pyridinato-N,C³]iridium(acetyl-acetonate)) and Ir(piq)₃ (tris(1-phenylisoquinoline)iridium) which emit red light. Specific examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, and dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the organic electronic material described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

### [Hole Transport Layer, Hole Injection Layer]

In FIG. 1, the hole injection layer 3 and the hole transport layer 6 are organic layers formed using the organic electronic material described above, but the organic EL element is not limited to this type of structure, and one or more other organic layers may be formed using the organic electronic material described above. The organic EL element preferably has the organic layer as at least one of a hole transport layer and a hole injection layer formed using the above organic electronic material, and more preferably has the organic layer as at least a hole transport layer. For example, in those cases where the organic EL element has a layer formed using the organic electronic material described above as a hole transport layer, and also has a hole injection layer, a conventional material may be used for the hole injection layer. Further, in those cases where the organic EL element has an organic layer formed using the organic electronic material described above as a hole injection layer, and also has a hole transport layer, a conventional material may be used for the hole transport layer.

Further, examples of conventional materials include aromatic amine-based compounds (for example, aromatic diamines such as N,N'-di(naphthalen-1-yl)-N,N'-diphenyl-benzidine (α-NPD)), phthalocyanine-based compounds, and thiophene-based compounds (for example, thiophene-based conductive polymers (such as poly(3,4-ethylenedioxythiophene):poly(4-styrenesulfonate) (PEDOT:PSS) and the like).

### [Electron Transport Layer, Electron Injection Layer]

Examples of materials that can be used for forming the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives (for example, 2,2',2"-(1,3,5-benzenetriyl)tris(1-phenyl-1H-benzimidazole) (TPBi)), quinoxaline derivatives, and aluminum complexes (for example, aluminum bis(2-methyl-8-quinolinolate)-4-(phenylphenolate) (BAlq)). Further, the organic electronic material described above may also be used.

### [Cathode]

Examples of the cathode material include metals or metal alloys, such as Li, Ca, Mg, Al, In, Cs, Ba, Mg/Ag, LiF and CsF.

### [Anode]

Metals (for example, Au) or other materials having conductivity can be used as the anode. Examples of the other materials include oxides (for example, ITO: indium oxide/tin oxide, and conductive polymers (for example, polythiophene-polystyrene sulfonate mixtures (PEDOT:PSS)).

### [Substrate]

Glass and plastics and the like can be used as the substrate. The substrate is preferably transparent, and a substrate having flexibility is preferred. Quartz glass and light-transmitting resin films and the like can be used particularly favorably.

Examples of the resin films include films containing polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.

In those cases where a resin film is used, an inorganic substance such as silicon oxide or silicon nitride may be coated onto the resin film to inhibit the transmission of water vapor and oxygen and the like.

### [Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.

The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or for yellowish green and orange or the like. Control of the emission color can be achieved by appropriate adjustment of the types and amounts of the light-emitting materials.

### <Display Element, Illumination Device, Display Device>

According to one embodiment, a display element contains the organic EL element described above. For example, by using the organic EL element as the element corresponding with each color pixel of red, green and blue (RGB), a color display element can be obtained. Examples of the image formation method include a simple matrix in which individual organic EL elements arrayed in a panel are driven directly by an electrode arranged in a matrix, and an active matrix in which a thin-film transistor is positioned on, and drives, each element.

Further, according to one embodiment, an illumination device contains the organic EL element described above. Moreover, according to another embodiment, a display device contains the illumination device and a liquid crystal element as a display unit. For example, the display device may be a device that uses the illumination device as a backlight, and uses a conventional liquid crystal element as the display unit, namely a liquid crystal display device.

### Examples

Embodiments of the present invention are described below in detail using a series of examples. However, the embodiments of the present invention are not limited to the following examples.

### <Monomer Synthesis Examples>

Synthesis examples of monomers having a crosslinking group represented by formula (1) and monomers having a crosslinking group represented by formula (2) are described below, but the synthesis method is not limited to the following method.

### (Synthesis Example 1)

A monomer T1-2 having the structure shown below was synthesized using the method described below. Specifically, synthesis was performed using the sequence shown below.

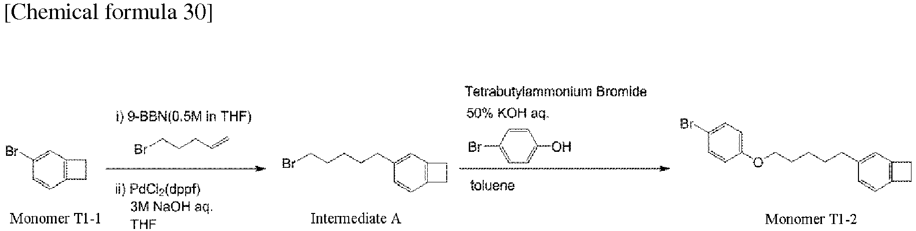

In a 300 mL three-neck flask under a nitrogen atmosphere, 5-bromo-1-pentene (7.45 g, 50 mmol) and tetrahydrofuran (20 mL) were mixed together to obtain a solution. A 0.5 M 9-BBN/THF solution (9-borabicyclo[3.3.1]nonane tetrahydrofuran solution) (100 mL) was added dropwise to the obtained solution over a period of one hour, and the resulting mixture was stirred at room temperature for 12 hours. A monomer T1-1 (3.66 g, 20 mmol), ((diphenylphosphino)ferrocene)palladium dichloride (0.82 g), tetrahydrofuran (32 mL) and a 3 M aqueous solution of sodium hydroxide (27 mL) were mixed with the thus obtained reaction solution and refluxed for 4 hours. Following completion of the reaction, the obtained solution was cooled to room temperature, hexane (40 mL) was added, and with the resulting solution cooled in an ice bath, hydrogen peroxide water (6 mL) was added gradually to the flask in a dropwise manner, and the resulting mixture was then stirred for one hour. The reaction mixture was then separated, and the organic layer was washed 5 times with ion-exchanged water (50 mL). The thus obtained organic layer was dried over sodium sulfate, and then purified by column chromatography using a silica gel filler and using hexane as the eluent, thus obtaining an intermediate A (3.80 g, 15 mmol).

In a 50 mL two-neck flask under a nitrogen atmosphere, the intermediate A (3.80 g, 15 mmol), 4-bromophenol (3.89 g, 22.5 mmol), tetrabutylammonium bromide (0.16 g, 0.5 mmol), a 50% aqueous solution of potassium hydroxide (6.7 g) and toluene (20 mL) were mixed together and then refluxed for 6 hours. Following completion of the reaction, the obtained solution was washed three times with ion-exchanged water (10 mL). The resulting organic layer was dried over sodium sulfate, and then purified by column chromatography using a silica gel filler and using a mixed solvent of hexane/ethyl acetate (95/5) as the eluent, thus obtaining a monomer T1-2 (4.14 g, 12 mmol).

### (Synthesis Example 2)

A monomer T1-3 having the structure shown below was synthesized using the method described below. Specifically, synthesis was performed using the sequence shown below.

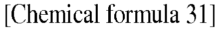

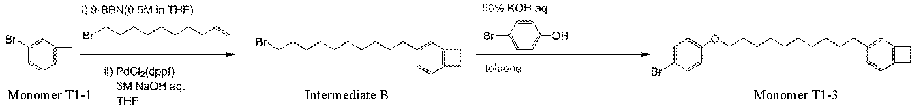

With the exception of using 10-bromo-1-decene (10.96 g, 50 mmol) instead of the 5-bromo-1-pentene (7.45 g, 50 mmol), synthesis was conducted using the same procedure as Synthesis Example 1, yielding an intermediate B (4.53 g, 14 mmol).

With the exceptions of using the intermediate B (4.53 g, 14 mmol) instead of the intermediate A (3.80 g, 15 mmol) and adjusting the equivalence ratio, a monomer T1-3 (4.99 g, 12 mmol) was obtained using the same procedure as Synthesis Example 1.

### (Synthesis Example 3)

A monomer T1-4 having the structure shown below was synthesized using the method described below. Specifically, synthesis was performed using the sequence shown below.

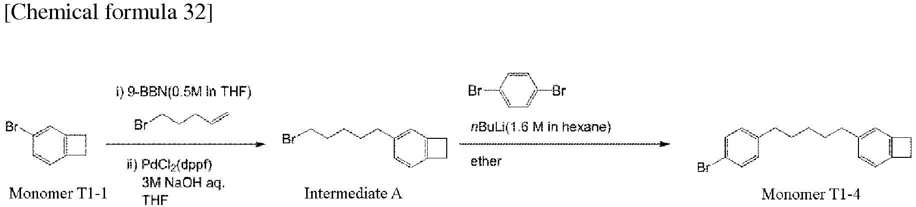

The intermediate A (3.80 g, 15 mmol) was obtained in the same manner as Synthesis Example 1.

In a 200 mL three-neck flask under a nitrogen atmosphere, 1,4-dibromobenzene (3.54 g, 15 mmol) and ether (30 mL) were mixed together, and the obtained solution was cooled to -78°C. A 1.6 M hexane solution of n-butyllithium (9.4 mL) was added dropwise to the solution over a period of 30 minutes, and the resulting mixture was then stirred at -78°C for two hours. Subsequently, the intermediate A (3.80 g, 15 mmol) was added in a dropwise manner and stirred at -78°C for 30 minutes. The temperature was then returned to room temperature, and stirring was continued for 12 hours. The obtained mixture was separated, and the resulting organic layer was dried over sodium sulfate and then purified by column chromatography using a silica gel filler and using hexane as the eluent, thus obtaining a monomer T1-4 (2.96 g, 9 mmol).

### (Synthesis Example 4)

A monomer T1-5 having the structure shown below was synthesized using the method described below. Specifically, synthesis was performed using the sequence shown below.

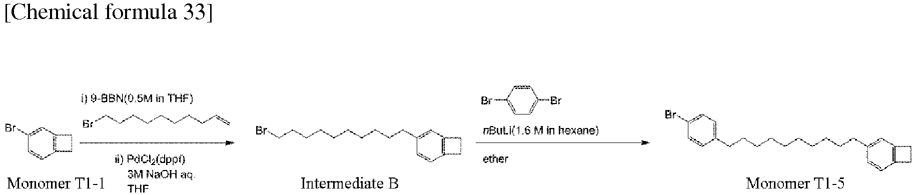

With the exceptions of using the intermediate B (4.99 g, 12 mmol) instead of the intermediate A (3.80 g, 15 mmol) and adjusting the equivalence ratio, a monomer T1-5 (2.40 g, 6 mmol) was obtained using the same procedure as Synthesis Example 3.

### (Synthesis Example 5)

A monomer T2-2 having the structure shown below was synthesized using the method described below. Specifically, synthesis was performed using the sequence shown below.

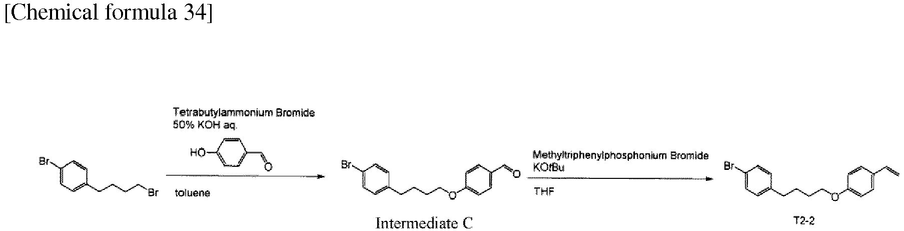

In a 100 mL three-neck flask under a nitrogen atmosphere, 1-bromo-4-(4-bromobutyl)benzene (11.68 g, 40 mmol), 4-hydroxybenzaldehyde (7.33 g , 60 mmol), tetrabutylammonium bromide (0.644 g , 2 mmol), a 50% aqueous solution of potassium hydroxide (26.93 g) and toluene (40 mL) were mixed together and then refluxed for 6 hours. Following completion of the reaction, the obtained solution was washed three times with ion-exchanged water (10 mL). The resulting organic layer was dried over sodium sulfate, and then purified by column chromatography using a silica gel filler and using a mixed solvent of hexane/ethyl acetate (90/10) as the eluent, thus obtaining an intermediate C (10.55 g, 31.7 mmol).

In a 200 mL three-neck flask under a nitrogen atmosphere, methyltriphenylphosphonium bromide (21.33 g, 59.7 mmol), potassium t-butoxide (6.70 g, 59.7 mmol) and tetrahydrofuran (60 mL) were mixed together at 0°C and then stirred at room temperature for one hour. Subsequently, a solution of the intermediate C (10.55 g, 31.7 mmol) dissolved in tetrahydrofuran (15 mL) was added to the flask at 0°C, and the resulting mixture was stirred at room temperature for 24 hours. Following completion of the reaction, the tetrahydrofuran was removed by distillation using an evaporator, the residue was dissolved in toluene (20 mL), and the thus obtained solution was washed three times with ion-exchanged water (10 mL). The resulting organic layer was dried over sodium sulfate, and then purified by column chromatography using a silica gel filler and using a mixed solvent of hexane/ethyl acetate (90/10) as the eluent, thus obtaining a monomer T2-2 (9.28 g, 28 mmol).

### (Synthesis Example 6)

A monomer T2-3 having the structure shown below was synthesized using the method described below. Specifically, synthesis was performed using the sequence shown below.

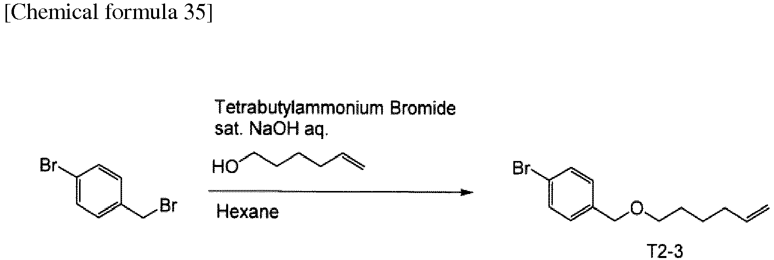

In a 200 mL three-neck flask under a nitrogen atmosphere, p-bromobenzyl bromide (10.9 g, 43.5 mmol), 5-hexen-1-ol (4.36 g, 43.5 mmol), tetraethylammonium bromide (0.70 g, 2.18 mmol), hexane (100 mL) and a saturated aqueous solution of NaOH (50 mL) were refluxed under heat for 5 hours. The thus obtained reaction solution was washed three times with ion-exchanged water (10 mL). The reaction solution was then dried over sodium sulfate, the sodium sulfate was removed by filtration, and the solvent was removed by distillation to obtain 11.7 g of a colorless liquid. This liquid was further dried in a vacuum, yielding a monomer T2-3 (11.3 g, 41.9 mmol).

### (Synthesis Example 7)

A monomer T2-4 having the structure shown below was synthesized using the method described below. Specifically, synthesis was performed using the sequence shown below.

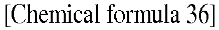

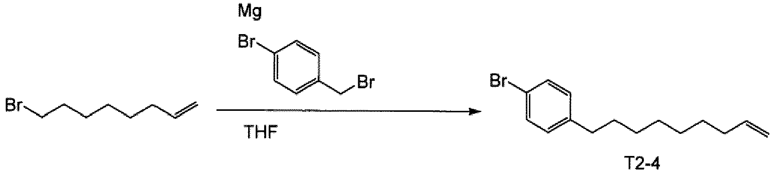

Under a nitrogen atmosphere, a 100 ml three-neck flask was charged with magnesium (0.53 g, 22 mmol) and tetrahydrofuran (10 mL). Next, a solution prepared by dissolving 8-bromo-1-octene (3.82 g, 20 mmol) in tetrahydrofuran (20 mL) was added dropwise to the flask over a period of 20 minutes. Subsequently, 4-bromobenzyl bromide (5.50 g, 22 mmol) was added to the obtained solution, and following stirring at room temperature for one hour, the mixture was refluxed under heat for 3 hours. The thus obtained solution was washed three times with ion-exchanged water (10 mL). The solution was then dried over sodium sulfate, the sodium sulfate was removed by filtration, and the solvent was removed by distillation. The product was purified by column chromatography, yielding a monomer T2-4 (2.81 g, 10 mmol).

### (Synthesis Example 8)

A monomer T2-5 having the structure shown below was synthesized using the method described below. Specifically, synthesis was performed using the sequence shown below.

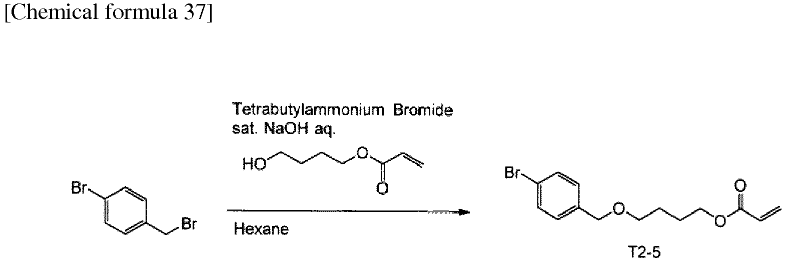

With the exception of replacing the 5-hexen-1-ol (6.27 g, 43.5 mmol) with 4-hydroxybutyl acrylate, a monomer T2-5 (12.52 g, 40 mmol) was obtained in the same manner as Synthesis Example 6.

### (Synthesis Example 9)

A monomer T2-6 having the structure shown below was synthesized using the method described below. Specifically, synthesis was performed using the sequence shown below.

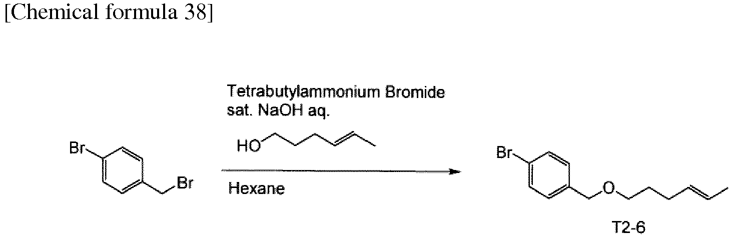

With the exception of replacing the 5-hexen-1-ol (6.27 g, 43.5 mmol) with 4-hexen-1-ol, a monomer T2-6 (10.76 g, 40 mmol) was obtained in the same manner as Synthesis Example 6.

### <Charge Transport Polymer Synthesis Examples>

### (Preparation of Pd Catalyst)

In a glove box under a nitrogen atmosphere at room temperature, tris(dibenzylideneacetone)dipalladium (73.2 mg, 80 µmol) was weighed into a sample tube, anisole (15 mL) was added, and the resulting mixture was agitated for 30 minutes. In a similar manner, tris(t-butyl)phosphine (129.6 mg, 640 µmol) was weighed into a sample tube, anisole (5 mL) was added, and the resulting mixture was agitated for 5 minutes. The two solutions were then mixed together and stirred for 30 minutes at room temperature to obtain a catalyst. All the solvents used were deaerated by nitrogen bubbling for at least 30 minutes prior to use.

### (Synthesis of Charge Transport Polymer 1)

A three-neck round-bottom flask was charged with a monomer L-1 shown below (5.0 mmol), a monomer B-1 shown below (2.0 mmol), a monomer T3-1 shown below (2.0 mmol), a monomer T3-2 shown below (2.0 mmol) and anisole (20 mL), and the prepared Pd catalyst solution (7.5 mL) was then added. After stirring for 30 minutes, a 10% aqueous solution of tetraethylammonium hydroxide (20 mL) was added. All of the solvents were deaerated by nitrogen bubbling for at least 30 minutes prior to use. The resulting mixture was heated and refluxed for two hours. All the operations up to this point were conducted under a stream of nitrogen.

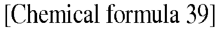

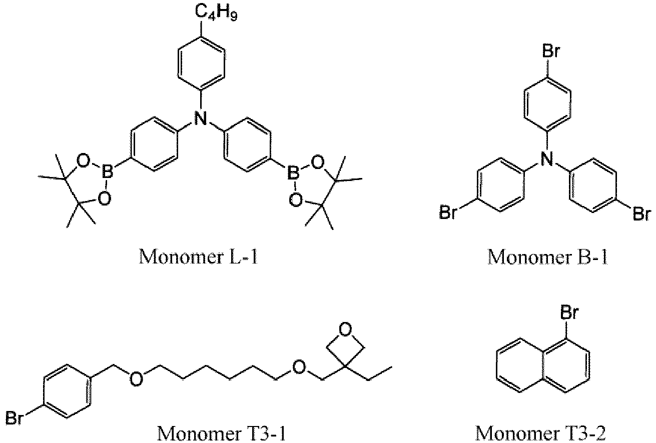

After completion of the reaction, the organic layer was washed with water and then poured into methanol-water (9:1). The resulting precipitate was collected by filtration under reduced pressure, and washed with methanol-water (9:1). The thus obtained precipitate was dissolved in toluene, and re-precipitated from methanol. The obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene, and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1.

The thus obtained charge transport polymer 1 had a number average molecular weight of 5,200 and a weight average molecular weight of 41,200. The charge transport polymer 1 had a structural unit L-1, a structural unit B-1, a structural unit T3-1 having an oxetane group, and a structural unit T3-2, and the proportions (molar ratios) of those structural units were 45.5%, 18.2%, 18.2% and 18.2% respectively. The structure is shown in the following formula. (The various structural units are shown in parentheses on the left, with the appended number for each structural unit indicating the molar ratio between the various structural units. An example of a partial structure assumed to be contained within the charge transport polymer is shown on the right. The same layout is also used for the syntheses of other transport polymers described below.)

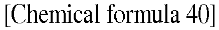

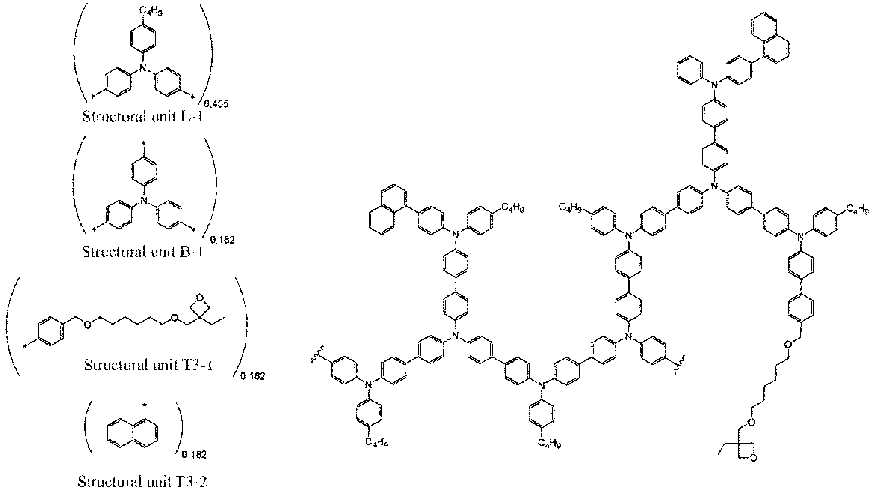

The number average molecular weight and the weight average molecular weight were measured by GPC (relative to polystyrene standards) using tetrahydrofuran (THF) as the eluent. The measurement conditions were as described above.

### (Synthesis of Charge Transport Polymer 2)

A three-neck round-bottom flask was charged with the monomer L-1 shown above (5.0 mmol), a monomer B-2 shown below (2.0 mmol), a monomer T1-1 shown below (0.3 mmol), a monomer T2-1 shown below (0.3 mmol), a monomer T3-3 shown below (3.4 mmol) and anisole (20 mL), and the prepared Pd catalyst solution (7.5 mL) was then added. Thereafter, a charge transport polymer 2 was synthesized in the same manner as the synthesis of the charge transport polymer 1.

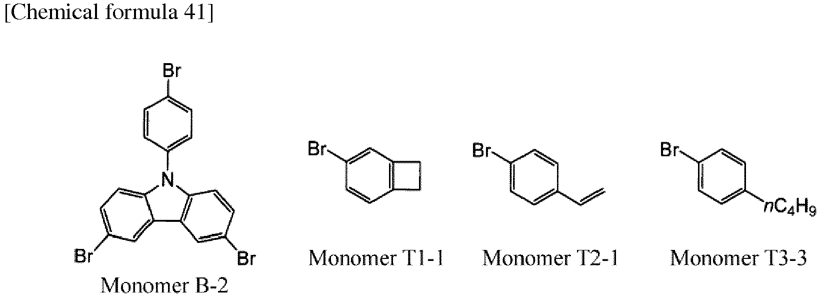

The thus obtained charge transport polymer 2 had a number average molecular weight of 12,600 and a weight average molecular weight of 63,400. The charge transport polymer 2 had a structural unit L-1, a structural unit B-2, a structural unit T1-1, a structural unit T2-1 and a structural unit T3-3, and the proportions (molar ratios) of those structural units were 45.5%, 18.2%, 2.8%, 2.8% and 30.7% respectively. In the charge transport polymer 2, the number of terminals having the crosslinking group (1) and the number of terminals having the crosslinking group (2) were 7.5% and 7.5% respectively of the total number of structural units T.

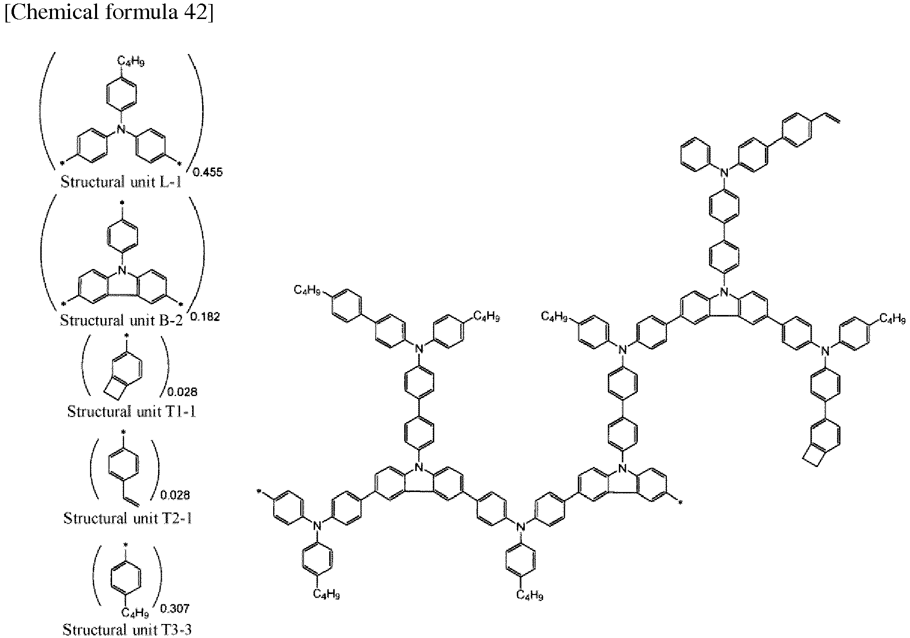

### (Synthesis of Charge Transport Polymer 3)

A three-neck round-bottom flask was charged with the monomer L-1 shown above (5.0 mmol), the monomer B-2 shown above (2.0 mmol), a monomer T1-2 shown below (0.1 mmol), a monomer T2-2 shown below (0.2 mmol), the monomer T3-3 shown above (3.7 mmol) and anisole (20 mL), and the prepared Pd catalyst solution (7.5 mL) was then added. Thereafter, a charge transport polymer 3 was synthesized in the same manner as the synthesis of the charge transport polymer 1.

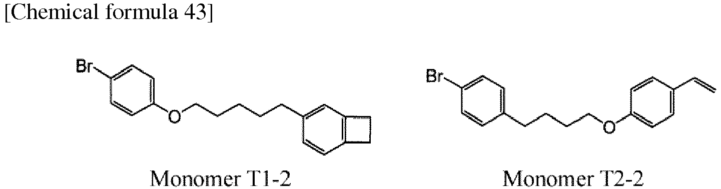

The thus obtained charge transport polymer 3 had a number average molecular weight of 12,600 and a weight average molecular weight of 57,600. The charge transport polymer 3 had a structural unit L-1, a structural unit B-2, a structural unit T1-2, a structural unit T2-2 and a structural unit T3-3, and the proportions (molar ratios) of those structural units were 45.5%, 18.2%, 0.90%, 1.80% and 33.6% respectively. In the charge transport polymer 3, the number of terminals having the crosslinking group (1) and the number of terminals having the crosslinking group (2) were 2.5% and 5.0% respectively of the total number of structural units T.

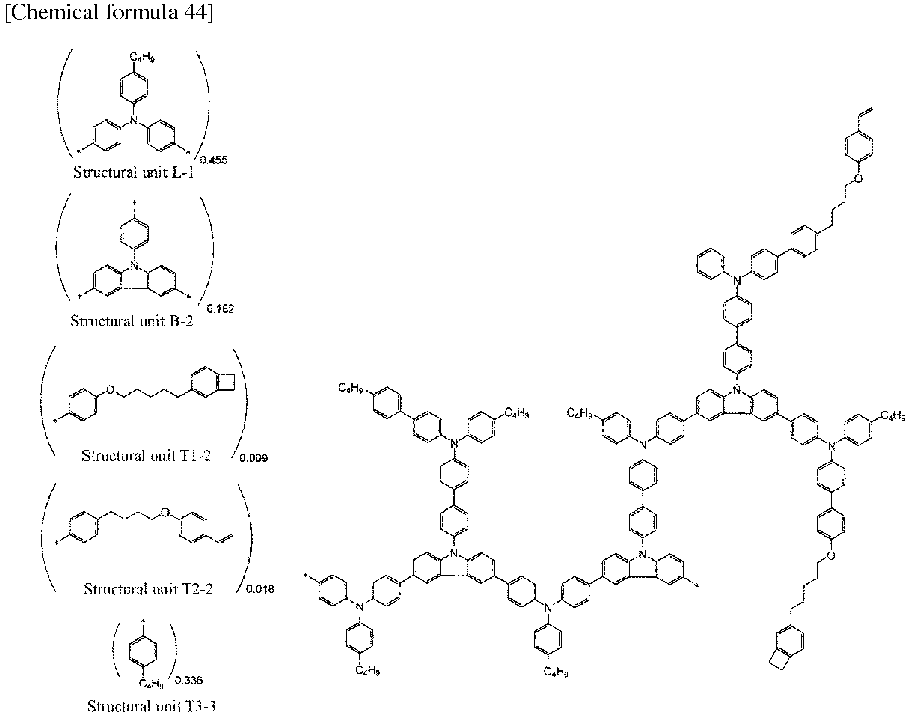

### (Synthesis of Charge Transport Polymer 4)

A three-neck round-bottom flask was charged with the monomer L-1 shown above (5.0 mmol), the monomer B-2 shown above (2.0 mmol), a monomer T1-2 shown below (0.1 mmol), a monomer T2-3 shown below (0.1 mmol), the monomer T3-3 shown above (3.8 mmol) and anisole (20 mL), and the prepared Pd catalyst solution (7.5 mL) was then added. Thereafter, a charge transport polymer 4 was synthesized in the same manner as the synthesis of the charge transport polymer 1.

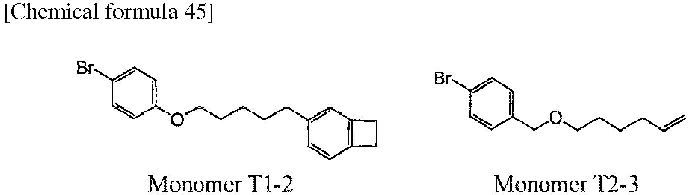

The thus obtained charge transport polymer 4 had a number average molecular weight of 12,100 and a weight average molecular weight of 60,500. The charge transport polymer 4 had a structural unit L-1, a structural unit B-2, a structural unit T1-2, a structural unit T2-3 and a structural unit T3-3, and the proportions (molar ratios) of those structural units were 45.5%, 18.2%, 0.90%, 0.90% and 34.5% respectively. In the charge transport polymer 4, the number of terminals having the crosslinking group (1) and the number of terminals having the crosslinking group (2) were 2.5% and 2.5% respectively of the total number of structural units T.

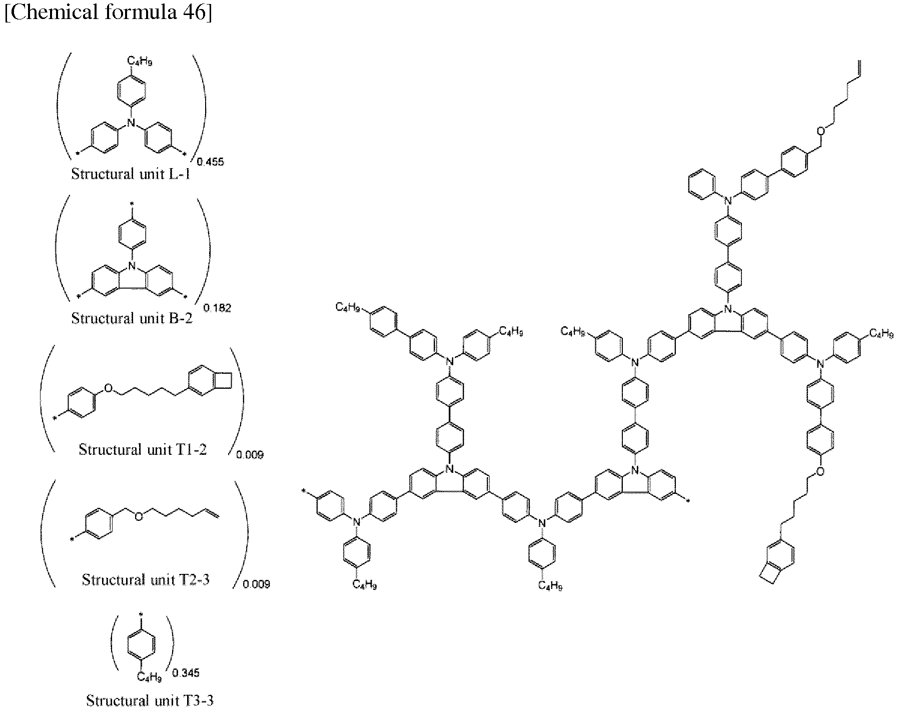

### (Synthesis of Charge Transport Polymer 5)

A three-neck round-bottom flask was charged with the monomer L-1 shown above (5.0 mmol), the monomer B-2 shown above (2.0 mmol), a monomer T1-2 shown below (0.1 mmol), a monomer T2-4 shown below (0.1 mmol), the monomer T3-3 shown above (3.8 mmol) and anisole (20 mL), and the prepared Pd catalyst solution (7.5 mL) was then added. Thereafter, a charge transport polymer 5 was synthesized in the same manner as the synthesis of the charge transport polymer 1.

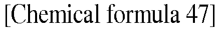

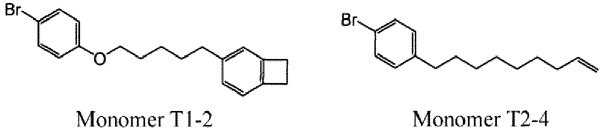

The thus obtained charge transport polymer 5 had a number average molecular weight of 11,500 and a weight average molecular weight of 60,000. The charge transport polymer 5 had a structural unit L-1, a structural unit B-2, a structural unit T1-2, a structural unit T2-4 and a structural unit T3-3, and the proportions (molar ratios) of those structural units were 45.5%, 18.2%, 0.90%, 0.90% and 34.5% respectively. In the charge transport polymer 5, the number of terminals having the crosslinking group (1) and the number of terminals having the crosslinking group (2) were 2.5% and 2.5% respectively of the total number of structural units T.

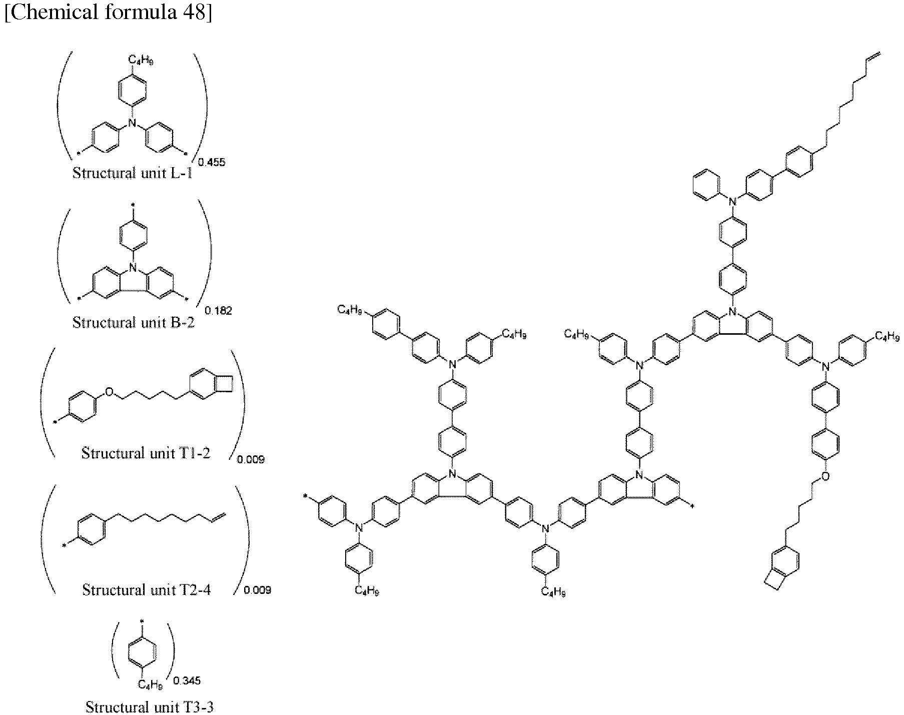

### (Synthesis of Charge Transport Polymer 6)

A three-neck round-bottom flask was charged with the monomer L-1 shown above (5.0 mmol), the monomer B-2 shown above (2.0 mmol), a monomer T1-3 shown below (0.1 mmol), a monomer T2-4 shown below (0.1 mmol), the monomer T3-3 shown above (3.8 mmol) and anisole (20 mL), and the prepared Pd catalyst solution (7.5 mL) was then added. Thereafter, a charge transport polymer 6 was synthesized in the same manner as the synthesis of the charge transport polymer 1.

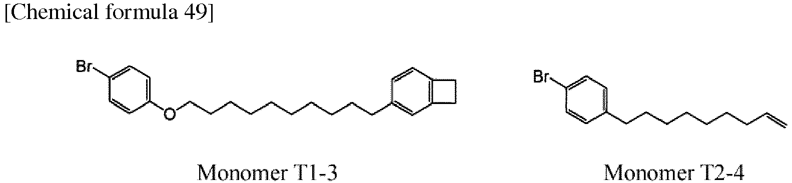

The thus obtained charge transport polymer 6 had a number average molecular weight of 12,200 and a weight average molecular weight of 61,000. The charge transport polymer 6 had a structural unit L-1, a structural unit B-2, a structural unit T1-3, a structural unit T2-4 and a structural unit T3-3, and the proportions (molar ratios) of those structural units were 45.5%, 18.2%, 0.90%, 0.90% and 34.5% respectively. In the charge transport polymer 6, the number of terminals having the crosslinking group (1) and the number of terminals having the crosslinking group (2) were 2.5% and 2.5% respectively of the total number of structural units T.

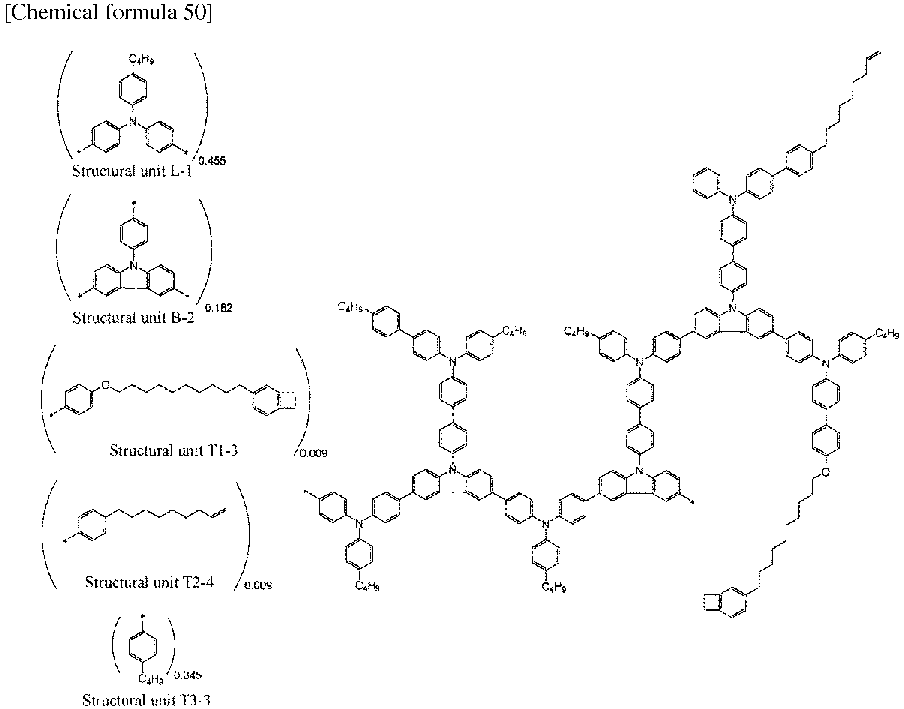

### (Synthesis of Charge Transport Polymer 7)

A three-neck round-bottom flask was charged with the monomer L-1 shown above (5.0 mmol), the monomer B-2 shown above (2.0 mmol), a monomer T1-4 shown below (0.1 mmol), a monomer T2-4 shown below (0.1 mmol), the monomer T3-3 shown above (3.8 mmol) and anisole (20 mL), and the prepared Pd catalyst solution (7.5 mL) was then added. Thereafter, a charge transport polymer 7 was synthesized in the same manner as the synthesis of the charge transport polymer 1.

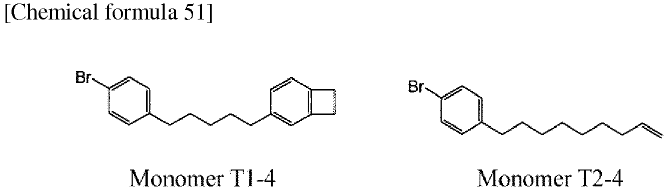

The thus obtained charge transport polymer 7 had a number average molecular weight of 13,200 and a weight average molecular weight of 62,000. The charge transport polymer 7 had a structural unit L-1, a structural unit B-2, a structural unit T1-4, a structural unit T2-4 and a structural unit T3-3, and the proportions (molar ratios) of those structural units were 45.5%, 18.2%, 0.90%, 0.90% and 34.5% respectively. In the charge transport polymer 7, the number of terminals having the crosslinking group (1) and the number of terminals having the crosslinking group (2) were 2.5% and 2.5% respectively of the total number of structural units T.

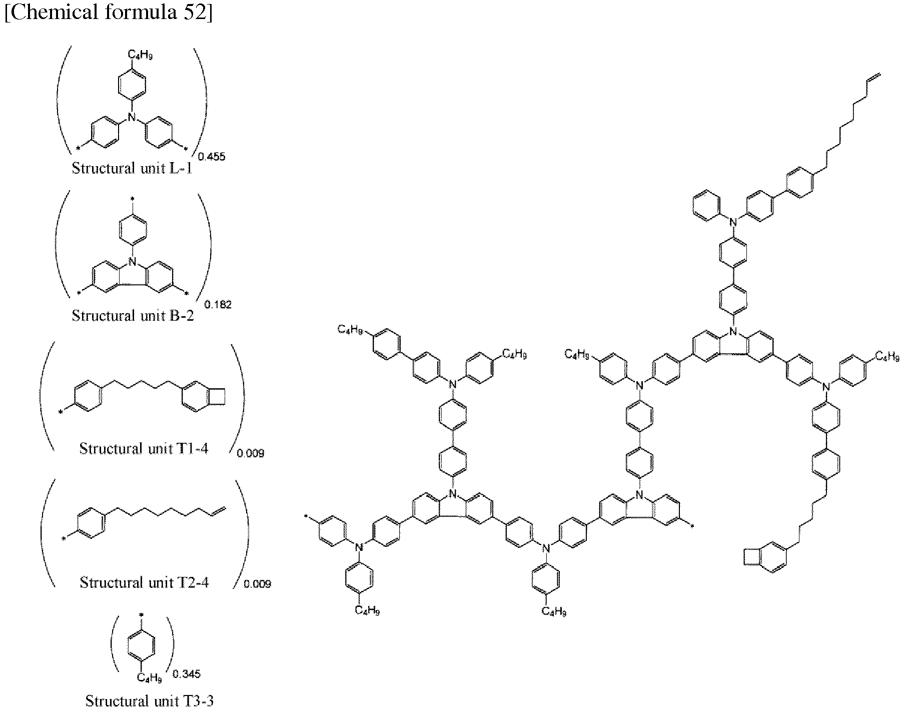

### (Synthesis of Charge Transport Polymer 8)

A three-neck round-bottom flask was charged with the monomer L-1 shown above (5.0 mmol), the monomer B-2 shown above (2.0 mmol), a monomer T1-5 shown below (0.1 mmol), a monomer T2-4 shown below (0.1 mmol), the monomer T3-3 shown above (3.8 mmol) and anisole (20 mL), and the prepared Pd catalyst solution (7.5 mL) was then added. Thereafter, a charge transport polymer 8 was synthesized in the same manner as the synthesis of the charge transport polymer 1.

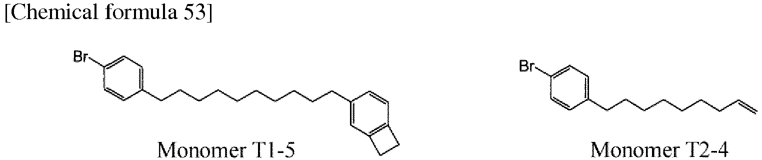

The thus obtained charge transport polymer 8 had a number average molecular weight of 13,500 and a weight average molecular weight of 60,000. The charge transport polymer 8 had a structural unit L-1, a structural unit B-2, a structural unit T1-5, a structural unit T2-4 and a structural unit T3-3, and the proportions (molar ratios) of those structural units were 45.5%, 18.2%, 0.90%, 0.90% and 34.5% respectively. In the charge transport polymer 8, the number of terminals having the crosslinking group (1) and the number of terminals having the crosslinking group (2) were 2.5% and 2.5% respectively of the total number of structural units T.

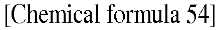

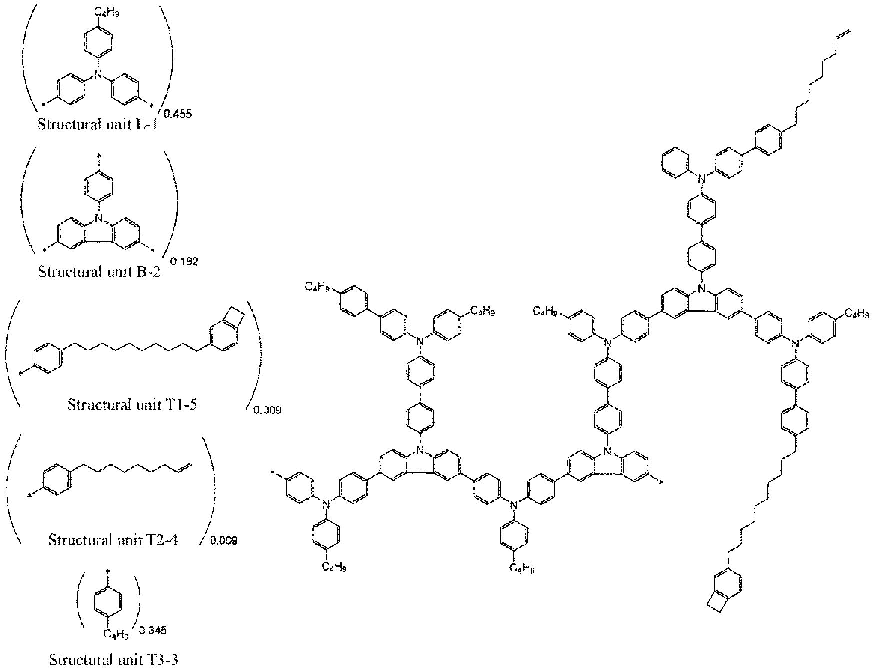

### (Synthesis of Charge Transport Polymer 9)

A three-neck round-bottom flask was charged with the monomer L-1 shown above (5.0 mmol), the monomer B-2 shown above (2.0 mmol), a monomer T1-4 shown below (0.1 mmol), a monomer T2-5 shown below (0.1 mmol), the monomer T3-3 shown above (3.8 mmol) and anisole (20 mL), and the prepared Pd catalyst solution (7.5 mL) was then added. Thereafter, a charge transport polymer 9 was synthesized in the same manner as the synthesis of the charge transport polymer 1.

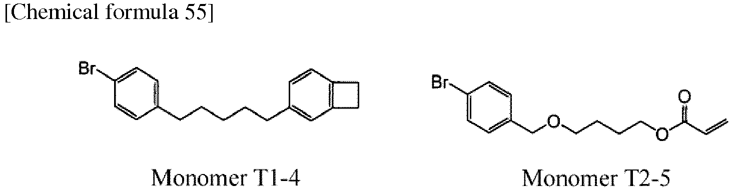

The thus obtained charge transport polymer 9 had a number average molecular weight of 12,500 and a weight average molecular weight of 59,700. The charge transport polymer 9 had a structural unit L-1, a structural unit B-2, a structural unit T1-4, a structural unit T2-5 and a structural unit T3-3, and the proportions (molar ratios) of those structural units were 45.5%, 18.2%, 0.90%, 0.90% and 34.5% respectively. In the charge transport polymer 9, the number of terminals having the crosslinking group (1) and the number of terminals having the crosslinking group (2) were 2.5% and 2.5% respectively of the total number of structural units T.

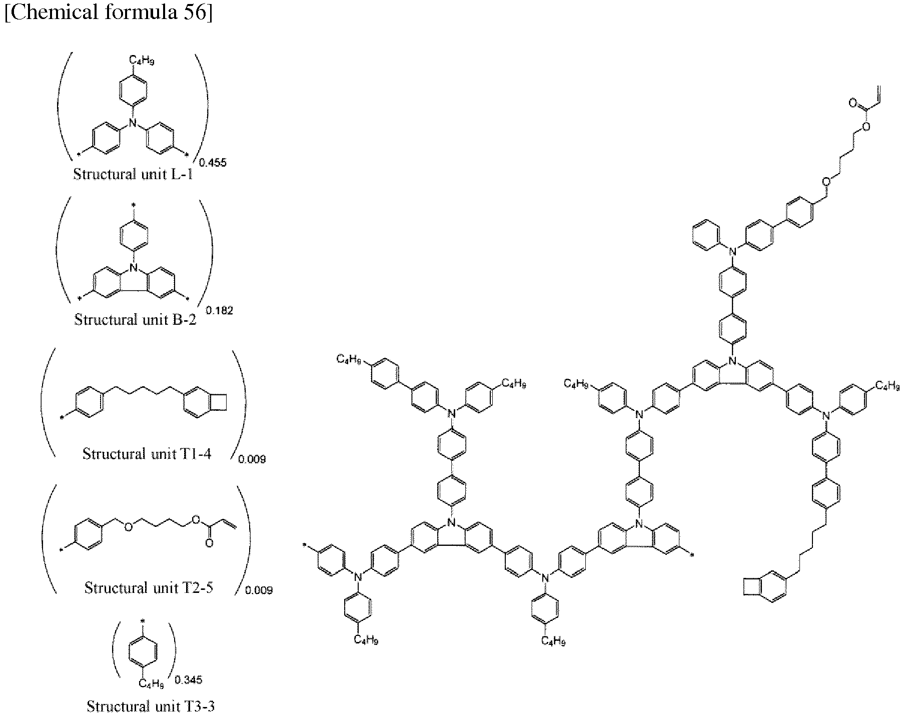

### (Synthesis of Charge Transport Polymer 10)

A three-neck round-bottom flask was charged with the monomer L-1 shown above (5.0 mmol), the monomer B-2 shown above (2.0 mmol), a monomer T1-4 shown below (0.1 mmol), a monomer T2-6 shown below (0.1 mmol), the monomer T3-3 shown above (3.8 mmol) and anisole (20 mL), and the prepared Pd catalyst solution (7.5 mL) was then added. Thereafter, a charge transport polymer 10 was synthesized in the same manner as the synthesis of the charge transport polymer 1.

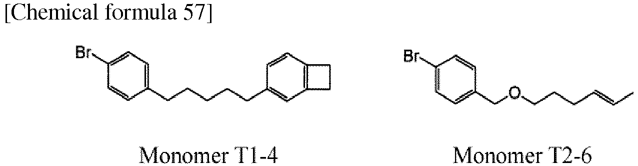

The thus obtained charge transport polymer 10 had a number average molecular weight of 11,000 and a weight average molecular weight of 59,000. The charge transport polymer 10 had a structural unit L-1, a structural unit B-2, a structural unit T1-4, a structural unit T2-6 and a structural unit T3-3, and the proportions (molar ratios) of those structural units were 45.5%, 18.2%, 0.90%, 0.90% and 34.5% respectively. In the charge transport polymer 10, the number of terminals having the crosslinking group (1) and the number of terminals having the crosslinking group (2) were 2.5% and 2.5% respectively of the total number of structural units T.

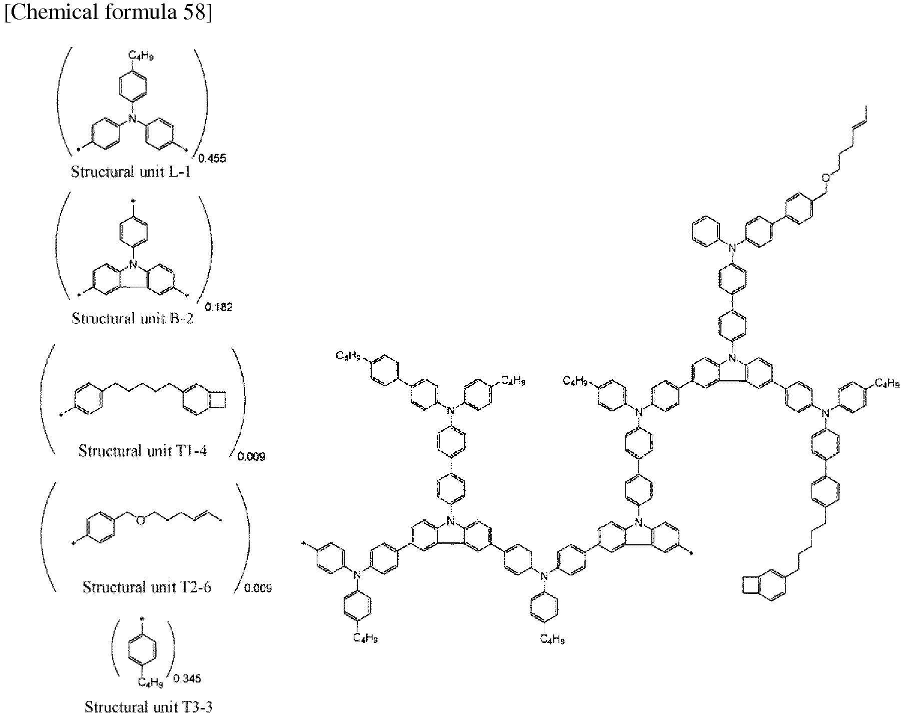

### (Synthesis of Charge Transport Polymer 11)

A three-neck round-bottom flask was charged with the monomer L-1 shown above (5.0 mmol), the monomer B-2 shown above (2.0 mmol), the monomer T3-1 shown above (0.6 mmol), the monomer T3-3 shown above (3.4 mmol) and anisole (20 mL), and the prepared Pd catalyst solution (7.5 mL) was then added. Thereafter, a charge transport polymer 11 was synthesized in the same manner as the synthesis of the charge transport polymer 1.

The thus obtained charge transport polymer 11 had a number average molecular weight of 16,300 and a weight average molecular weight of 62,600. The charge transport polymer 11 had a structural unit L-1, a structural unit B-2, a structural unit T3-1 having an oxetane group and a structural unit T3-3, and the proportions (molar ratios) of those structural units were 45.5%, 18.2%, 5.6% and 30.7% respectively.

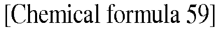

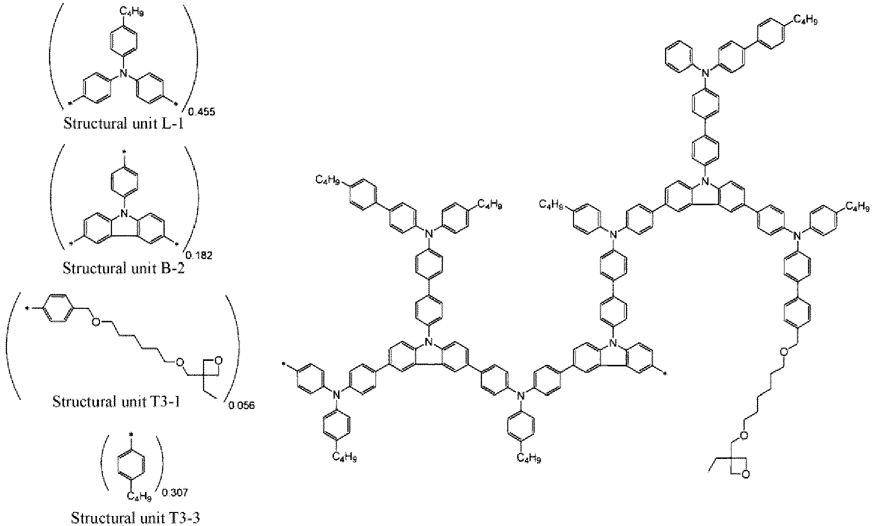

### (Synthesis of Charge Transport Polymer 12)

A three-neck round-bottom flask was charged with the monomer L-1 shown above (5.0 mmol), the monomer B-2 shown above (2.0 mmol), a monomer T2-1 shown below (0.6 mmol), the monomer T3-3 shown above (3.4 mmol) and anisole (20 mL), and the prepared Pd catalyst solution (7.5 mL) was then added. Thereafter, a charge transport polymer 12 was synthesized in the same manner as the synthesis of the charge transport polymer 1.

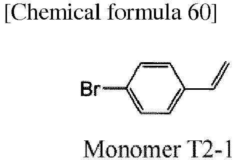

The thus obtained charge transport polymer 12 had a number average molecular weight of 14,500 and a weight average molecular weight of 53,900. The charge transport polymer 12 had a structural unit L-1, a structural unit B-2, a structural unit T2-1 having a vinyl group and a structural unit T3-3, and the proportions (molar ratios) of those structural units were 45.5%, 18.2%, 5.6% and 30.7% respectively.

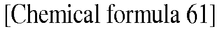

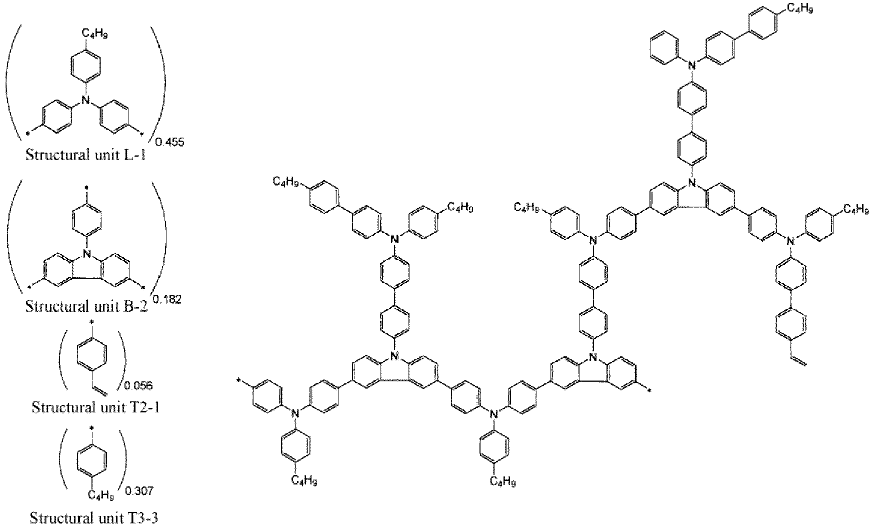

### (Synthesis of Charge Transport Polymer 13)

A three-neck round-bottom flask was charged with the monomer L-1 shown above (5.0 mmol), the monomer B-2 shown above (2.0 mmol), the monomer T1-1 shown above (0.6 mmol), the monomer T3-3 shown above (3.4 mmol) and anisole (20 mL), and the prepared Pd catalyst solution (7.5 mL) was then added. Thereafter, a charge transport polymer 13 was synthesized in the same manner as the synthesis of the charge transport polymer 1.

The thus obtained charge transport polymer 13 had a number average molecular weight of 14,500 and a weight average molecular weight of 53,900. The charge transport polymer 13 had a structural unit L-1, a structural unit B-2, a structural unit T1-1 having a benzocyclobutene group and a structural unit T3-3, and the proportions (molar ratios) of those structural units were 45.5%, 18.2%, 5.6% and 30.7% respectively.

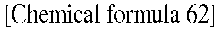

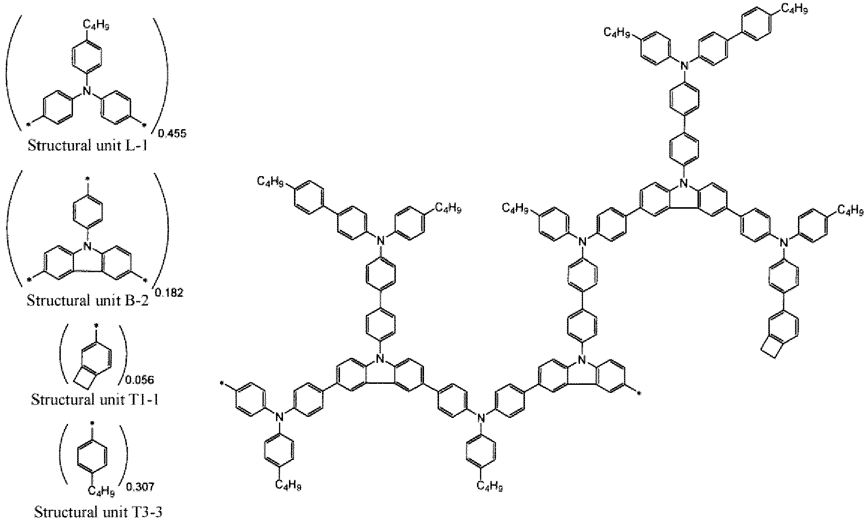

### [Examples 1 to 9 and Comparative Examples 1 to 3]

### <Measurement and Evaluation of Organic Layer Residual Film Ratio>

### (Preparation of Liquid Compositions)

Each of the charge transport polymers 2 to 13 was dissolved in toluene to prepare a 1% by mass liquid composition (toluene solution) of each of the charge transport polymers.

### (Evaluation of Residual Film Ratio on Glass Substrate)

Each of the liquid compositions was dripped onto a glass substrate, and film formation was conducted using a spin coater (MS-A100, manufactured by Mikasa Co., Ltd.) under conditions including a rotational rate of 3,000 min⁻¹ for 60 seconds. Subsequently, using a high-power hot plate (ND-3H, manufactured by AS ONE Corporation) in a glove box under a nitrogen atmosphere, the film on the glass substrate was baked at 230°C for 30 minutes. The absorbance (Abs.1) of the obtained film at the absorption maximum wavelength was measured using a spectrophotometer (U-3310, manufactured by Hitachi High-Technologies Corporation).

Subsequently, the glass substrate was immersed in toluene (25°C) for 10 seconds, and the toluene was then dried at normal temperature. The absorbance (Abs.2) of the thus obtained film at the absorption maximum wavelength was then re-measured using the spectrophotometer (U-3310, manufactured by Hitachi High-Technologies Corporation).

The value of (Abs.2/Abs.1) × 100 (%) was calculated as the residual film ratio. This residual film ratio (units: %) is shown in Table 1.

### [Table 1]

**Table 1**

| | Charge transport polymer | Residual film ratio (%) |
|---|---|---|
| Example 1 | Charge transport polymer 2 | 85 |
| Example 2 | Charge transport polymer 3 | 96 |
| Example 3 | Charge transport polymer 4 | 97 |
| Example 4 | Charge transport polymer 5 | 99 |
| Example 5 | Charge transport polymer 6 | 100 |
| Example 6 | Charge transport polymer 7 | 100 |
| Example 7 | Charge transport polymer 8 | 100 |
| Example 8 | Charge transport polymer 9 | 96 |
| Example 9 | Charge transport polymer 10 | 95 |
| Comparative Example 1 | Charge transport polymer 11 | 45 |
| Comparative Example 2 | Charge transport polymer 12 | 48 |
| Comparative Example 3 | Charge transport polymer 13 | 65 |

The films (organic layers) obtained in Examples 1 to 9 exhibited a higher residual film ratio compared with the films obtained in Comparative Examples 1 to 3. This confirmed that the organic layer according to one embodiment has superior curability. It was confirmed that charge transport polymers having a vinyl structure and a benzocyclobutene structure as crosslinking groups at the polymer terminals were suitable materials for performing stacking of organic layers.

### [Examples 10 to 18 and Comparative Examples 4 to 6]

### <Production of Organic EL Elements>

An ink composition for forming a hole injection layer was prepared under a nitrogen atmosphere by mixing the charge transport polymer 1 (10.0 mg), an electron-accepting compound 1 shown below (0.5 mg) and toluene (2.3 mL). This ink composition was spin-coated at a rotational rate of 3,000 min⁻¹ onto a glass substrate on which ITO had been patterned with a width of 1.6 mm, and the ink composition was then cured by heating at 220°C for 10 minutes on a hot plate, thus forming a hole injection layer (25 nm).

In the production of the organic EL element, an MS-A100 device manufactured by Mikasa Co., Ltd. was used as the spin-coater, and an ND-3H device manufactured by AS ONE Corporation was used as the hot plate.

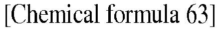

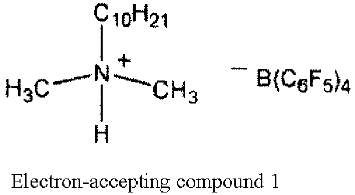

Next, one of the charge transport polymers shown in Table 2 (10.0 mg) and toluene (1.15 mL) were mixed to prepare an ink composition for forming a hole transport layer. This ink composition was spin-coated at a rotational rate of 3,000 min⁻¹ onto the hole injection layer formed above, and was then cured by heating at 200°C for 10 minutes on a hot plate, thus forming a hole transport layer (40 nm). In each example and each comparative example, the hole transport layer was able to be formed without dissolving the hole injection layer.

### [Table 2]

**Table 2**

| | Hole Injection Layer | Hole Transport Layer |
|---|---|---|
| Example 10 | Charge transport polymer 1 | Charge transport polymer 2 |
| | Electron-accepting compound 1 | |
| Example 11 | Charge transport polymer 1 | Charge transport polymer 3 |
| | Electron-accepting compound 1 | |
| Example 12 | Charge transport polymer 1 | Charge transport polymer 4 |
| | Electron-accepting compound 1 | |
| Example 13 | Charge transport polymer 1 | Charge transport polymer 5 |
| | Electron-accepting compound 1 | |
| Example 14 | Charge transport polymer 1 | Charge transport polymer 6 |
| | Electron-accepting compound 1 | |
| Example 15 | Charge transport polymer 1 | Charge transport polymer 7 |
| | Electron-accepting compound 1 | |
| Example 16 | Charge transport polymer 1 | Charge transport polymer 8 |
| | Electron-accepting compound 1 | |
| Example 17 | Charge transport polymer 1 | Charge transport polymer 9 |
| | Electron-accepting compound 1 | |
| Example 18 | Charge transport polymer 1 | Charge transport polymer 10 |
| | Electron-accepting compound 1 | |
| Comparative Example 4 | Charge transport polymer 1 | Charge transport polymer 11 |
| | Electron-accepting compound 1 | |
| Comparative Example 5 | Charge transport polymer 1 | Charge transport polymer 12 |
| | Electron-accepting compound 1 | |
| Comparative Example 6 | Charge transport polymer 1 | Charge transport polymer 13 |
| | Electron-accepting compound 1 | |

Each of the glass substrates obtained above was transferred into a vacuum deposition apparatus, layers of CBP:Ir(ppy)₃ (94:6, 30 nm), BAlq (10 nm), TPBi (30 nm), LiF (0.8 nm) and Al (100 nm) were deposited in that order using deposition methods on top of the hole transport layer, and an encapsulation treatment was performed to complete production of an organic EL element.

When a voltage was applied to each of the organic EL elements, green light emission was confirmed in each case. For each element, the emission lifespan (luminance half-life) when the initial luminance was 5,000 cd/m² was measured. The measurement results are shown in Table 3.

### [Table 3]

**Table 3**

| | Hole Injection Layer | Hole Transport Layer | Emission Lifespan (h) |
|---|---|---|---|
| Example 10 | Charge transport polymer 1 | Charge transport polymer 2 | 242 |
| | Electron-accepting compound 1 | | |
| Example 11 | Charge transport polymer 1 | Charge transport polymer 3 | 310 |
| | Electron-accepting compound 1 | | |
| Example 12 | Charge transport polymer 1 | Charge transport polymer 4 | 290 |
| | Electron-accepting compound 1 | | |
| Example 13 | Charge transport polymer 1 | Charge transport polymer 5 | 305 |
| | Electron-accepting compound 1 | | |
| Example 14 | Charge transport polymer 1 | Charge transport polymer 6 | 295 |
| | Electron-accepting compound 1 | | |
| Example 15 | Charge transport polymer 1 | Charge transport polymer 7 | 309 |
| | Electron-accepting compound 1 | | |
| Example 16 | Charge transport polymer 1 | Charge transport polymer 8 | 280 |
| | Electron-accepting compound 1 | | |
| Example 17 | Charge transport polymer 1 | Charge transport polymer 9 | 259 |
| | Electron-accepting compound 1 | | |
| Example 18 | Charge transport polymer 1 | Charge transport polymer 10 | 291 |
| | Electron-accepting compound 1 | | |
| Comparative Example 4 | Charge transport polymer 1 | Charge transport polymer 11 | 200 |
| | Electron-accepting compound 1 | | |
| Comparative Example 5 | Charge transport polymer 1 | Charge transport polymer 12 | 210 |
| | Electron-accepting compound 1 | | |
| Comparative Example 6 | Charge transport polymer 1 | Charge transport polymer 13 | 190 |
| | Electron-accepting compound 1 | | |

In Examples 10 to 18, elements of longer lifespan were able to be obtained compared with Comparative Examples 4 to 6. It was confirmed that organic electronic materials containing a charge transport polymer having a vinyl structure and a benzocyclobutene structure as crosslinking groups at the polymer terminals was suitable for improving the characteristics of organic electronic elements.

### Reference Signs List

- 1:: Light-emitting layer
- 2:: Anode
- 3:: Hole injection layer
- 4:: Cathode
- 5:: Electron injection layer
- 6:: Hole transport layer
- 7:: Electron transport layer
- 8:: Substrate

## Claims

1. An organic electronic material comprising a charge transport polymer or oligomer having a crosslinking group represented by a formula (1) shown below at least at one terminal, and also having a crosslinking group represented by a formula (2) shown below at least at one terminal: 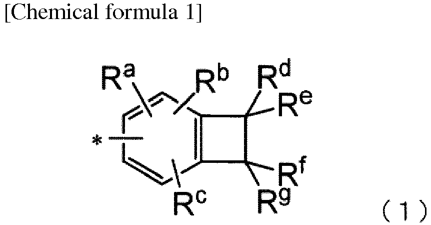 wherein each of R^{a} to R^{g} independently represents a hydrogen atom or a substituent, 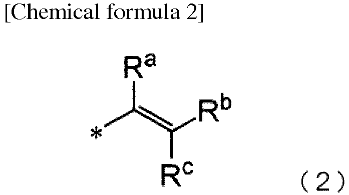 wherein each of R^{a} to R^{c} independently represents a hydrogen atom or a substituent.

2. The organic electronic material according to Claim 1, wherein the charge transport polymer or oligomer has at least three terminals.

3. The organic electronic material according to Claim 1 or 2, wherein
the charge transport polymer or oligomer comprises at least a divalent structural unit L and a monovalent structural unit T,
the structural unit L includes a structural unit containing at least one type of structure selected from the group consisting of a substituted or unsubstituted aromatic amine structure and a substituted or unsubstituted carbazole structure, and
the monovalent structural unit T includes a monovalent structural unit T1 containing a crosslinking group represented by the formula (1) and a monovalent structural unit T2 containing a crosslinking group represented by the formula (2).

4. The organic electronic material according to any one of Claims 1 to 3, wherein
the charge transport polymer or oligomer further comprises at least one type of structural unit selected from the group consisting of a trivalent or higher structural unit B, and a monovalent structural unit T3 that does not contain a crosslinking group represented by the formula (1) or a crosslinking group represented by the formula (2),
the structural unit B includes a structural unit containing at least one type of structure selected from the group consisting of a substituted or unsubstituted aromatic amine structure, a substituted or unsubstituted carbazole structure, and a substituted or unsubstituted condensed polycyclic aromatic hydrocarbon structure, and
the structural unit T3 includes a structural unit containing a substituted or unsubstituted aromatic ring structure.

5. The organic electronic material according to Claim 3 or 4, wherein adjacent structural units selected from the group consisting of the structural unit L, the structural unit T and the optionally included structural unit B are bonded together by direct bonding of aromatic rings.

6. The organic electronic material according to Claim 1 or 2, wherein the charge transport polymer or oligomer is a copolymer of monomers including at least a difunctional monomer containing a structural unit having charge transport properties, a monofunctional monomer T1 containing a crosslinking group represented by the formula (1), and a monofunctional monomer T2 containing a crosslinking group represented by the formula (2).

7. The organic electronic material according to Claim 1 or 2, wherein the charge transport polymer or oligomer is a copolymer of monomers including at least a difunctional monomer containing a structural unit having hole transport properties, a monofunctional monomer T1 containing a crosslinking group represented by the formula (1), and a monofunctional monomer T2 containing a crosslinking group represented by the formula (2).

8. A liquid composition comprising the organic electronic material according to any one of Claims 1 to 7, and a solvent.

9. An organic layer formed using the organic electronic material according to any one of Claims 1 to 7, or the liquid composition according to Claim 8.

10. An organic electronic element comprising at least one of the organic layer according to Claim 9.

11. An organic electronic element comprising at least an anode and cathode pair, and at least one of the organic layer according to Claim 9 disposed between the anode and the cathode.

12. An organic electroluminescent element comprising at least one of the organic layer according to Claim 9.

13. An organic electroluminescent element comprising at least a substrate, an anode, a light-emitting layer and a cathode, wherein the light-emitting layer is the organic layer according to Claim 9.

14. An organic electroluminescent element comprising at least a substrate, an anode, a hole injection layer, a hole transport layer, a light-emitting layer and a cathode, wherein
at least one layer selected from the group consisting of the hole injection layer, the hole transport layer and the light-emitting layer is the organic layer according to Claim 9.

15. An organic electroluminescent element comprising at least a substrate, an anode, a hole injection layer, a hole transport layer, a light-emitting layer, an electron transport layer, an electron injection layer and a cathode, wherein
at least one layer selected from the group consisting of the hole injection layer, the hole transport layer and the light-emitting layer is the organic layer according to Claim 9.

16. The organic electroluminescent element according to any one of Claims 13 to 15, wherein the substrate is a flexible substrate.

17. The organic electroluminescent element according to any one of Claims 13 to 16, wherein the substrate is a resin film substrate.

18. A display element comprising the organic electroluminescent element according to any one of Claims 12 to 16.

19. An illumination device comprising the organic electroluminescent element according to any one of Claims 12 to 16.

20. A display device comprising the illumination device according to Claim 19, and a liquid crystal element as a display unit.
